# EUROPEAN PATENT APPLICATION

(11) **EP 2 333 841 A2**
(43) Date of publication of application: **15.06.2011**
(21) Application number: 11160292.6
(22) Date of filing: 18.04.2007
(51) Int. Cl.: H01L 31/0392, H01L 31/18

(54) **Cadmium telluride-based photovoltaic device and method of preparing the same**

(30) Priority: 18.04.2006 US 792773 P
(62) Divisional of application: 07775581.7
(71) Applicant: Dow Corning Corporation, Midland, MI 48686-0994 (US)
(72) Inventor: Katsoulis, Dimitris, Midland, MI 48642 (US); Zhu, Bizhong, Midland, MI 48640 (US)
(74) Representative: Neilson, Martin Mark

(57) **Abstract**

A cadmium telluride (CdTe)-based photovoltaic device (104) includes a CdTe layer including cadmium and telluride. The CdTe-based photovoltaic device further includes a substrate (106) including a silicone layer (306) formed from a silicone composition. The substrate (106), because it includes the silicone layer (306) formed from the silicone composition, is both flexible and sufficiently able to withstand annealing temperatures in excess of 350°C, and frequently in excess of 500°C, to obtain maximum efficiency of the device.

## Description

### RELATED APPLICATIONS

This patent application claims priority to and all advantages of United States Provisional Patent Application Nos. 60/792,773 filed on April 18, 2006.

### FIELD OF THE INVENTION

The present invention generally relates to a cadmium telluride-based photovoltaic device and a method of preparing the photovoltaic device. More specifically, the invention relates to a photovoltaic device that includes a polymeric substrate or a substrate including a polymer layer.

### BACKGROUND OF THE INVENTION

Cadmium telluride (CdTe)-based photovoltaic devices are well known for generating electricity from sunlight and other sources of light. The CdTe-based photovoltaic devices are useful for providing electricity for any application in which the devices are exposed to the source of light. As a result, the potential applications for CdTe-based photovoltaic devices are far-reaching.

To date, the CdTe-based photovoltaic devices have been limited in the applications for which they may be used due to an inverse correlation between versatility and efficiency. More specifically, in order to be cost-effective, the photovoltaic devices must generate electricity at an efficiency that makes the cost-per-unit of electricity on par with or lower than traditional sources of electricity, such as batteries. In order to prepared CdTe-based photovoltaic devices having suitable efficiency, the devices are subjected to annealing at temperatures in excess of 350 °C, and frequently in excess of 500 °C, in different environments.

To date, few materials have proven useful for the substrate in the CdTe-based photovoltaic devices due to an inability to sufficiently resist cracking and mechanical failure at the annealing temperatures in excess of 500 °C. Various types of glass are predominantly used as the substrate; however, glass adds weight to the devices and is typically rigid. The rigidity of the glass substrates renders the devices unsuitable for applications that require flexibility or applications in which the devices may be subjected to blunt force that could crack or otherwise damage the glass substrates. In addition to limiting potential applications for the devices, the glass substrates also require that the devices be individually prepared. More specifically, if a suitable flexible substrate were to be discovered, roll-to-roll preparation of the devices may be possible, which would greatly increase production efficiency and lower the costs of preparing the devices. A decrease in the weight of the substrate would also be advantageous for obvious reasons.

Certain flexible substrates formed from polyimide have been recently developed for use in CdTe-based photovoltaic devices. The polyimide substrates eliminate the deficiencies of the glass substrates as to excessive weight and inflexibility; however, the polyimide substrates are prone to cracking and mechanical failure at temperatures in excess of 425 °C. As such, the devices including the polyimide substrate cannot be properly annealed to maximize efficiency of the devices.

Due to the deficiencies of the existing CdTe-based photovoltaic devices including glass or polyimide substrates, there remains an opportunity to provide a CdTe-based photovoltaic device including a substrate that is both flexible and sufficiently able to withstand annealing temperatures in excess of 350 °C, and frequently in excess of 500 °C, to obtain maximum efficiency of the device.

### SUMMARY OF THE INVENTION AND ADVANTAGES

The present invention provides a cadmium telluride (CdTe)-based photovoltaic device and a method of preparing the same. The CdTe-based device includes a CdTe layer including cadmium and telluride. The CdTe-based photovoltaic device further includes a substrate including a silicone layer formed from a silicone composition. The substrate, because it includes the silicone layer formed from the silicone composition, is both flexible and sufficiently able to withstand annealing temperatures in excess of 350 °C, and frequently in excess of 500 °C, to obtain maximum efficiency of the device.

### BRIEF DESCRIPTION OF THE FIGURES

Other advantages of the present invention will be readily appreciated, as the same becomes better understood by reference to the following detailed description when considered in connection with the accompanying drawings wherein:

Figure 1 is a photograph of a cadmium telluride (CdTe)-based photovoltaic device of the present invention;

Figure 2 is a top plan view of a CdTe-based photovoltaic device of the present invention;

Figure 3 is a schematic of a substrate for a CdTe-based photovoltaic device **104** of the present invention, the substrate having a fiber reinforcement;

Figure 4 is a schematic side cross-sectional view of another embodiment of a substrate for a CdTe-based photovoltaic device of the present invention, the substrate having a silicone layer and a metal foil layer; and

Figure 5 is a schematic cross-sectional side view of a CdTe-based photovoltaic device of the present invention illustrating order of layers in the device.

### DETAILED DESCRIPTION OF THE PREFERRED EMBODIMENTS

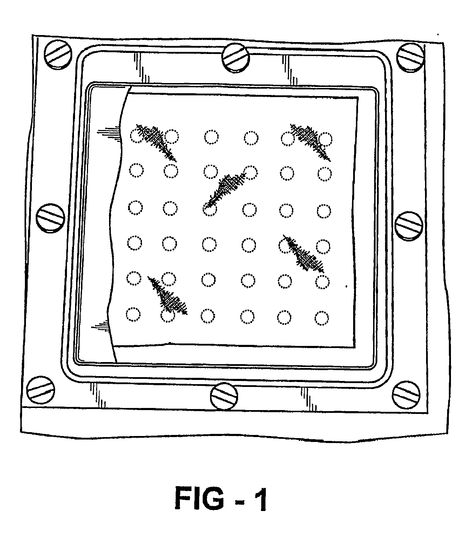

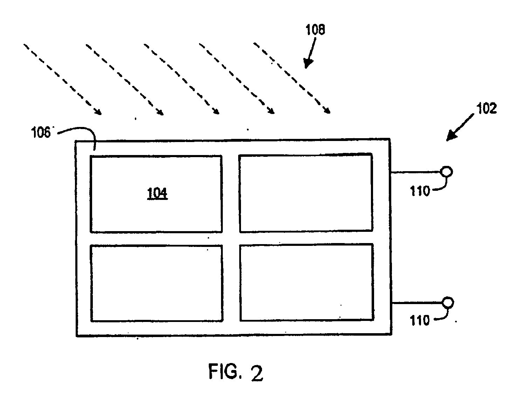

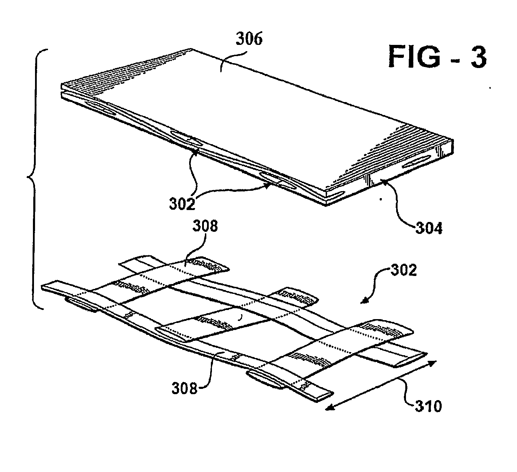

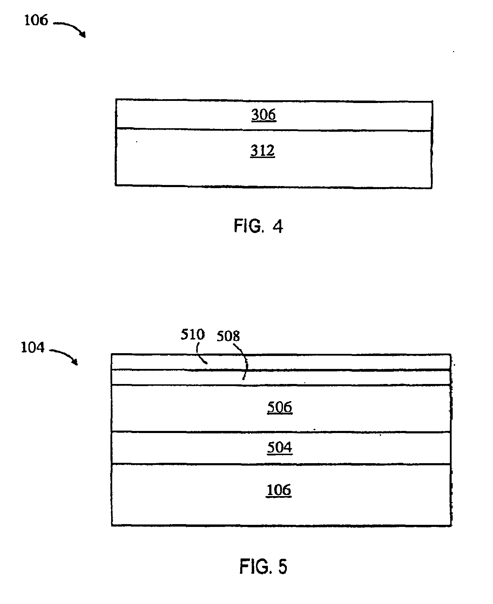

Referring to Figures 1 and 2, the present invention provides a cadmium telluride (CdTe)-based photovoltaic device **104** including a substrate **106**. The substrate **106** includes a silicone layer **306** formed from a silicone composition. Specifically, in one embodiment, shown in Figure 3, the substrate **106** includes the silicone layer **306** including a fiber reinforcement **302**. In another embodiment, shown in Figure 4, the substrate 106 includes a silicone layer **306** formed from the silicone composition and a metal foil layer **312**. An array **102** may be provided including a plurality of the CdTe-based photovoltaic devices **104**. The array **102** may be used to generate electric current from light **108** which falls on the array **102**. The electric current generated by the array **102**, which may be accessed via terminals **110**, may be used for a variety of purposes; for example, the array **102** may be used to provide electric power to spacecrafts or high altitude airships.

The silicone layer **306** provides the substrate **106** with flexibility and a sufficient ability to withstand annealing temperatures in excess of 350 °C, and frequently in excess of 500 °C, without exhibiting substantial cracking. Further, the silicone composition, once cured, typically has a high electrical resistivity. As a result, CdTe-based photovoltaic devices **104** may be prepared having maximized efficiency, as described in further detail below, and may further be used in non-planar applications due to the flexibility of the substrate **106**.

In one embodiment of the present invention, the silicone composition is further defined as a hydrosilylation-curable silicone composition including a silicone resin (A), an organosilicon compound (B), and a hydrosilylation catalyst (C). The silicone resin (A) typically has silicon-bonded alkenyl groups or silicon-bonded hydrogen atoms. The silicone resin (A) is typically a copolymer including R²SiO_{3/2} units, i.e., T units, and/or SiO_{4/2} units, i.e., Q units, in combination with R1R²₂SiO_{1/2} units, i.e., M units, and/or R²₂SiO_{2/2} units, i.e., D units, wherein R¹ is a C₁ to C₁₀ hydrocarbyl group or a C₁ to C₁₀ halogen-substituted hydrocarbyl group, both free of aliphatic unsaturation, and R² is R¹, an alkenyl group, or hydrogen. For example, the silicone resin can be a DT resin, an MT resin, an MDT resin, a DTQ resin, an MTQ resin, an MDTQ resin, a DQ resin, an MQ resin, a DTQ resin, an MTQ resin, or an MDQ resin. As used herein, the term "free of aliphatic unsaturation" means the hydrocarbyl or halogen-substituted hydrocarbyl group does not contain an aliphatic carbon-carbon double bond or carbon-carbon triple bond.

The C₁ to C₁₀ hydrocarbyl group and C₁ to C₁₀ halogen-substituted hydrocarbyl group represented by R¹ more typically have from 1 to 6 carbon atoms. Acyclic hydrocarbyl and halogen-substituted hydrocarbyl groups containing at least 3 carbon atoms can have a branched or unbranched structure. Examples of hydrocarbyl groups represented by R¹ include, but are not limited to, alkyl groups, such as methyl, ethyl, propyl, 1-methylethyl, butyl, 1-methylpropyl, 2-methylpropyl, 1,1-dimethylethyl, pentyl, 1-methylbutyl, 1-ethylpropyl, 2-methylbutyl, 3-methylbutyl, 1,2-dimethylpropyl, 2,2-dimethylpropyl, hexyl, heptyl, octyl, nonyl, and decyl; cycloalkyl groups, such as cyclopentyl, cyclohexyl, and methylcyclohexyl; aryl groups, such as phenyl and naphthyl; alkaryl groups, such as tolyl and xylyl; and aralkyl groups, such as benzyl and phenethyl. Examples of halogen-substituted hydrocarbyl groups represented by R¹ include, but are not limited to, 3,3,3-trifluoropropyl, 3-chloropropyl, chlorophenyl, dichlorophenyl, 2,2,2-trifluoroethyl, 2,2,3,3-tetrafluoropropyl, and 2,2,3,3,4,4,5,5-octafluoropentyl.

The alkenyl groups represented by R², which may be the same or different within the silicone resin, typically have from 2 to 10 carbon atoms, alternatively from 2 to 6 carbon atoms, and are exemplified by, but are not limited to, vinyl, allyl, butenyl, hexenyl, and octenyl. In one embodiment, R² is predominantly the alkenyl group. In this embodiment, typically at least 50 mol%, alternatively at least 65 mol%, alternatively at least 80 mol%, of the groups represented by R² in the silicone resin are alkenyl groups. As used herein, the mol% of alkenyl groups in R² is defined as a ratio of the number of moles of silicon-bonded alkenyl groups in the silicone resin to the total number of moles of the R² groups in the resin, multiplied by 100. In another embodiment, R² is predominantly hydrogen. In this embodiment, typically at least 50 mol%, alternatively at least 65 mol%, alternatively at least 80 mol%, of the groups represented by R² in the silicone resin are hydrogen. The mol% of hydrogen in R² is defined as a ratio of the number of moles of silicon-bonded hydrogen in the silicone resin to the total number of moles of the R² groups in the resin, multiplied by 100.

According to a first embodiment, the silicone resin (A) has the formula:

(R¹R²₂SiO1/2)w(R²₂SiO_{2/2})ₓ (R²SiO_{3/2})_{y}(SiO_{4/2})_{z} (I)

wherein R¹ and R² are as described and exemplified above and w, x, y, and z are mole fractions. Typically, the silicone resin represented by formula (I) has an average of at least two silicon-bonded alkenyl groups per molecule. More specifically, the subscript w typically has a value of from 0 to 0.9, alternatively from 0.02 to 0.75, alternatively from 0.05 to 0.3. The subscript x typically has a value of from 0 to 0.9, alternatively from 0 to 0.45, alternatively from 0 to 0.25. The subscript y typically has a value of from 0 to 0.99, alternatively from 0.25 to 0.8, alternatively from 0.5 to 0.8. The subscript z typically has a value of from 0 to 0.85, alternatively from 0 to 0.25, alternatively from 0 to 0.15. Also, the ratio y+z/(w+x+y+z) is typically from 0.1 to 0.99, alternatively from 0.5 to 0.95, alternatively from 0.65 to 0.9. Further, the ratio w+x/(w+x+y+z) is typically from 0.01 to 0.90, alternatively from 0.05 to 0.5, alternatively from 0.1 to 0.35.

When R² is predominantly the alkenyl group, specific examples of silicone resins represented by formula (I) above include, but are not limited to, resins having the following formulae:
(Vi₂MeSiO_{1/2})₀.₂₅(PhSiO_{3/2})₀.₇₅, (ViMe₂SiO_{1/2})_{0.25}(PhSiO_{3/2})_{0.75}, (ViMe₂SiO_{1/2})₀.₂₅(MeSiO_{3/2})₀.₂₅(PhSiO_{3/2})_{0.50}, (ViMe₂SiO_{1/2})₀.₁₅(PhSiO_{3/2})₀.₇₅(SiO_{4/2})₀.₁, and (Vi₂MeSiO_{1/2})0.15(ViMe₂SiO_{1/2})_{0.1}(PhSiO_{3/2})_{0.75},
wherein Me is methyl, Vi is vinyl, Ph is phenyl, and the numerical subscripts outside the parenthesis denote mole fractions corresponding to either w, x, y, or z as described above for formula (I). The sequence of units in the preceding formulae is not to be viewed in any way as limiting to the scope of the invention.

When R² is predominantly hydrogen, specific examples of silicone resins represented by formula (I) above include, but are not limited to, resins having the following formulae:
(HMe₂SiO_{1/2})₀.₂₅(PhSiO_{3/2})₀.₇₅, (HMeSiO_{2/2})₀.₃(PhSiO_{3/2})_{0.6}(MeSiO_{3/2})0.1, and (Me₃SiO_{1/2})_{0.1}(H₂SiO_{2/2})_{0.4}(MeSiO_{3/2})₀.₄(PhSiO_{3/2})₀.₄.
wherein Me is methyl, Ph is phenyl, and the numerical subscripts outside the parenthesis denote mole fractions. The sequence of units in the preceding formulae is not to be viewed in any way as limiting to the scope of the invention.

The silicone resin represented by formula (I) typically has a number-average molecular weight (Mₙ) of from 500 to 50,000, alternatively from 500 to 10,000, alternatively 1,000 to 3,000, where the molecular weight is determined by gel permeation chromatography employing a low angle laser light scattering detector, or a refractive index detector and silicone resin (MQ) standards.

The viscosity of the silicone resin represented by formula (I) at 25 °C is typically from 0.01 to 100,000 Pa·s, alternatively from 0.1 to 10,000 Pa·s, alternatively from 1 to 100 Pa·s.

The silicone resin represented by formula (I) typically includes less than 10% (w/w), alternatively less than 5% (w/w), alternatively less than 2% (w/w), of silicon-bonded hydroxy groups, as determined by ²⁹Si NMR.

Methods of preparing silicone resins represented by formula (I) are well known in the art; many of these resins are commercially available. Silicone resins represented by formula (I) are typically prepared by cohydrolyzing the appropriate mixture of chlorosilane precursors in an organic solvent, such as toluene. For example, a silicone resin including R¹R²₂SiO_{1/2} units and R²SiO_{3/2} units can be prepared by cohydrolyzing a first compound having the formula R¹R²₂SiCl and a second compound having the formula R²SiCl₃ in toluene, where R¹ and R² are as defined and exemplified above, to form aqueous hydrochloric acid and the silicone resin, which is a hydrolyzate of the first and second compounds. The aqueous hydrochloric acid and the silicone resin are separated, the silicone resin is washed with water to remove residual acid, and the silicone resin is heated in the presence of a mild condensation catalyst to "body" the silicone resin to a desired viscosity.

If desired, the silicone resin can be further treated with a condensation catalyst in an organic solvent to reduce the content of silicon-bonded hydroxy groups. Alternatively, first or second compounds containing hydrolysable groups other than chloro groups, such -Br, -I, -OCH₃, -OC(O)CH₃, -N(CH₃)₂, NHCOCH₃, and - SCH₃, can be cohydrolyzed to form the silicone resin. The properties of the silicone resin depend on the types of first and second compounds, the mole ratio of first and second compounds, the degree of condensation, and the processing conditions.

The hydrosilylation-curable silicone composition further includes a cross-linking agent (B) having silicon-bonded hydrogen atoms or silicon-bonded alkenyl groups capable of reacting with the silicon-bonded alkenyl groups or silicon-bonded hydrogen atoms in the silicone resin. The cross-linking agent (B) has an average of at least two silicon-bonded hydrogen atoms per molecule, alternatively at least three silicon-bonded hydrogen atoms per molecule. It is generally understood that cross-linking occurs when the sum of the average number of alkenyl groups per molecule in the silicone resin (A) and the average number of silicon-bonded hydrogen atoms per molecule in the cross-linking agent (B) is greater than four. The cross-linking agent (B) is present in an amount sufficient to cure the silicone resin (A).

The cross-linking agent (B) is typically an organosilicon compound and may be further defined as an organohydrogensilane, an organohydrogensiloxane, or a combination thereof. The structure of the organosilicon compound can be linear, branched, cyclic, or resinous. In acyclic polysilanes and polysiloxanes, the silicon-bonded hydrogen atoms can be located at terminal, pendant, or at both terminal and pendant positions. Cyclosilanes and cyclosiloxanes typically have from 3 to 12 silicon atoms, alternatively from 3 to 10 silicon atoms, alternatively from 3 to 4 silicon atoms.

The organohydrogensilane can be a monosilane, disilane, trisilane, or polysilane. When R² is predominantly the alkenyl group, specific examples of organohydrogensilanes that are suitable for purposes of the present invention include, but are not limited to, diphenylsilane, 2-chloroethylsilane, bis[(p-dimethylsilyl)phenyl]ether, 1,4-dimethyldisilylethane, 1,3,5-tris(dimethylsilyl)benzene, 1,3,5-trimethyl-1,3,5-trisilane, poly(methylsilylene)phenylene, and poly(methylsilylene)methylene. When R² is predominantly hydrogen, specific examples of organohydrogensilanes that are suitable for purposes of the present invention include, but are not limited to, silanes having the following formulae:
Vi₄Si, PhSiVi₃, MeSiVi₃, PhMeSiVi₂, Ph₂SiVi₂, and PhSi(CH₂CH=CH₂)₃,
wherein Me is methyl, Ph is phenyl, and Vi is vinyl.

The organohydrogensilane can also have the formula:

HR¹₂Si-R³-SiR¹₂H (III)

wherein R¹ is as defined and exemplified above and R³ is a hydrocarbylene group free of aliphatic unsaturation having a formula selected from the following structures: 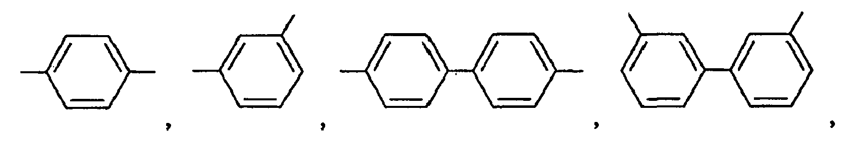 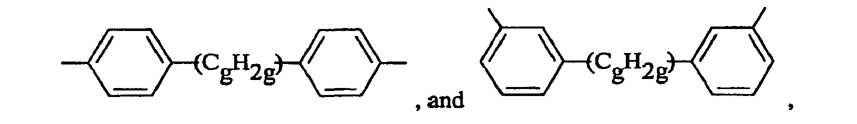 wherein g is from 1 to 6.

Specific examples of organohydrogensilanes having the formula (III), wherein R¹ and R³ are as described and exemplified above include, but are not limited to, organohydrogensilanes having a formula selected from the following structures: 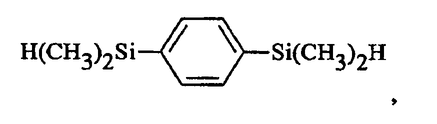 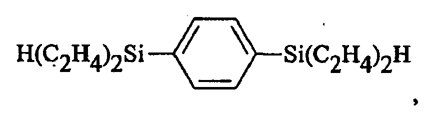 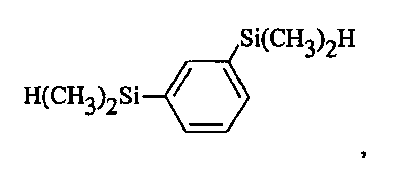 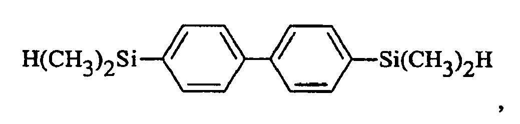 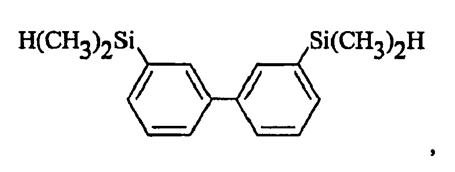 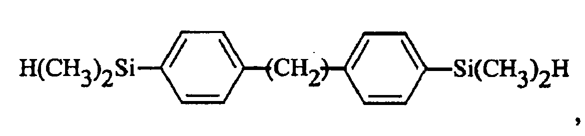 and

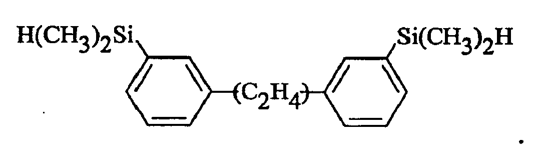

Methods of preparing the organohydrogensilanes are known in the art. For example, organohydrogensilanes can be prepared by reaction of Grignard reagents with alkyl or aryl halides. In particular, organohydrogensilanes having the formula HR¹₂Si-R³-SiR¹₂H can be prepared by treating an aryl dihalide having the formula R³X₂ with magnesium in ether to produce the corresponding Grignard reagent and then treating the Grignard reagent with a chlorosilane having the formula HR¹₂SiCl, where R¹and R³ are as described and exemplified above.

The organohydrogensiloxane can be a disiloxane, trisiloxane, or polysiloxane. Examples of organosiloxanes suitable for use as the cross-linking agent (B) when R² is predominantly hydrogen include, but are not limited to, siloxanes having the following formulae:
PhSi(OSiMe₂H)₃, Si(OSiMe₂H)₄, MeSi(OSiMe₂H)₃, and Ph₂Si(OSiMe₂H)₂,
wherein Me is methyl, and Ph is phenyl.

Specific examples of organohydrogensiloxanes that are suitable for purposes of the present invention when R² is predominantly alkenyl group include, but are not limited to, 1,1,3,3-tetramethyldisiloxane, 1,1,3,3-tetraphenyldisiloxane, phenyltris(dimethylsiloxy)silane, 1,3,5-trimethylcyclotrisiloxane, a trimethylsiloxy-terminated poly(methylhydrogensiloxane), a trimethylsiloxy-terminated poly(dimethylsiloxane/methylhydrogensiloxane), a dimethylhydrogensiloxy-terminated poly(methylhydrogensiloxane), and a resin including HMe₂SiO_{1/2} units, Me₃SiO_{1/2} units, and SiO_{4/2} units, wherein Me is methyl.

The organohydrogensiloxane can also be an organohydrogenpolysiloxane resin. The organohydrogenpolysiloxane resin is typically, a copolymer including R⁴SiO_{3/2} units, i.e., T units, and/or SiO_{4/2} units, i.e., Q units, in combination with R¹R⁴₂SiO_{1/2} units, i.e., M units, and/or R⁴₂SiO_{2/2} units, i.e., D units, wherein R¹ is as described and exemplified above. For example, the organohydrogenpolysiloxane resin can be a DT resin, an MT resin, an MDT resin, a DTQ resin, an MTQ resin, an MDTQ resin, a DQ resin, an MQ resin, a DTQ resin, an MTQ resin, or an MDQ resin.

The group represented by R⁴ is either R¹ or an organosilylalkyl group having at least one silicon-bonded hydrogen atom. Examples of organosilylalkyl groups represented by R⁴ include, but are not limited to, groups having a formula selected from the following structures: 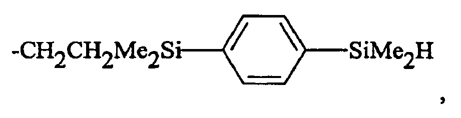 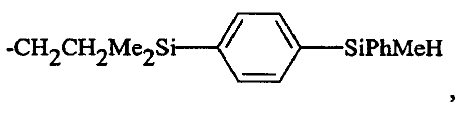 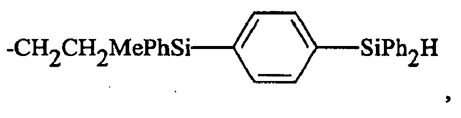 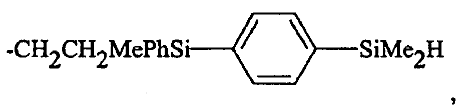 -CH₂CH₂SiMe₂H, -CH₂CH₂SiMe₂CₙH₂ₙSiMe₂H, -CH₂CH₂SiMe₂CₙH₂ₙSiMePhH, -CH₂CH₂SiMePhH, -CH₂CH₂SiPh₂H, -CH₂CH₂SiMePhCₙH₂ₙSiPh₂H, -CH₂CH₂SiMePhCₙH₂ₙSiMe₂H, -CH₂CH₂SiMePhOSiMePhH, and -CH₂CH₂SiMePhOSiPh(OSiMePhH)₂,
wherein Me is methyl, Ph is phenyl, and the subscript n has a value of from 2 to 10. Typically, at least 50 mol%, alternatively at least 65 mol%, alternatively at least 80 mol% of the groups represented by R⁴ in the organohydrogenpolysiloxane resin are organosilylalkyl groups having at least one silicon-bonded hydrogen atom. As used herein, the mol% of organosilylalkyl groups in R⁴ is defined as a ratio of the number of moles of silicon-bonded organosilylalkyl groups in the silicone resin to the total number of moles of the R⁴ groups in the resin, multiplied by 100.

The organohydrogenpolysiloxane resin typically has the formula:

(R¹R⁴₂SiO_{1/2})w(R⁴₂SiO_{2/2})ₓ(R⁴SiO_{3/2})_{y}(SiO_{4/2})_{z} (IV)

wherein R¹, R⁴ ,w, x, y, and z are each as defined and exemplified above.

Specific examples of organohydrogenpolysiloxane resins represent by formula (IV) above include, but are not limited to, resins having the following formulae:
((HMe₂SiC₆H₄SiMe₂CH₂CH₂)₂MeSiO_{1/2})₀.₁₂(PhSiO_{3/2})₀.₈₈,
((HMe₂SiC₆H₄SiMe₂CH₂CH₂)₂MeSiO_{1/2})₀.₁₇(PhSiO_{3/2})₀.₈₃,
((HMe₂SiC₆H₄SiMe₂CH₂CH₂)₂MeSiO_{1/2})_{0.17}(MeSiO_{3/2})_{0.17}(PhSiO_{3/2})_{0.66}, ((HMe₂SiC₆H₄SiMe₂CH₂CH₂)₂MeSiO_{1/2})₀.₁₅(PhSiO_{3/2})₀.₇₅(SiO_{4/2})₀.₁₀, and ((HMe₂SiC₆H₄SiMe₂CH₂CH₂)₂MeSiO_{1/2})_{0.08}((HMe₂SiC₆H₄SiMe₂CH₂CH₂)
Me₂SiO_{1/2})₀.₀₆(PhSiO_{3/2})₀.₈₆,
wherein Me is methyl, Ph is phenyl, C₆H₄ denotes a para-phenylene group, and the numerical subscripts outside the parenthesis denote mole fractions. The sequence of units in the preceding formulae is not to be viewed in any way as limiting to the scope of the invention.

Specific examples of organohydrogenpolysiloxane resins include, but are not limited to, resins having the following formulae:
((HMe₂SiC₆H₄SiMe₂CH₂CH₂)₂MeSiO_{1/2})₀.₁₂(PhSiO_{3/2})₀.₈₈,
((HMe₂SiC₆H₄SiMe₂CH₂CH₂)₂MeSiO_{l/2})₀.1₇(PhSiO_{3/2})₀.83,
((HMe₂SiC₆H₄SiMe₂CH₂CH₂)₂MeSiO_{1/2})₀.₁₇(McSiO_{3/2})₀.₁₇(PhSiO_{3/2})₀.₆₆,
((HMe₂SiC₆H₄SiMe₂CH₂CH₂)₂MeSiO_{1/2})₀.₁₅(PhSiO_{3/2})₀.₇₅(SiO_{4/2})₀.₁₀, and
((HMe₂SiC₆H₄SiMe₂CH₂CH₂)₂MeSi0_{1/2})_{0.08}((HMe₂SiC₆H₄SiMe₂CH₂CH₂) Me₂SiO_{1/2})_{0.06}(PhSiO_{3/2})_{0.86},
where Me is methyl, Ph is phenyl, C₆H₄ denotes apara-phenylene group, and the numerical subscripts outside the parenthesis denote mole fractions. The sequence of units in the preceding formulae is not to be viewed in any way as limiting to the scope of the invention.

The organohydrogenpolysiloxane resin having the formula (IV) can be prepared by reacting a reaction mixture including (a) a silicone resin having the formula (R¹R²₂SiO_{1/2})_{w}(R²₂SiO_{2/2})ₓ(R²SiO_{3/2})_{y}(SiO_{4/2})_{z} represented by formula (I) above and an organosilicon compound (b) having an average of from two to four silicon-bonded hydrogen atoms per molecule and a molecular weight of less than 1,000, in the presence of (c) a hydrosilylation catalyst and, optionally, (d) an organic solvent, wherein R¹, R², w, x, y, and z are each as defined and exemplified above, provided the silicone resin (a) has an average of at least two silicon-bonded alkenyl groups per molecule, and the mole ratio of silicon-bonded hydrogen atoms in (b) to alkenyl groups in (a) is from 1.5 to 5. Silicone resin (a) can be the same as or different than the specific silicone resin used as component (A) in the hydrosilylation-curable silicone composition.

As set forth above, organosilicon compound (b) has an average of from two to four silicon-bonded hydrogen atoms per molecule. Alternatively, the organosilicon compound (b) has an average of from two to three silicon-bonded hydrogen atoms per molecule. As also set forth above, the organosilicon compound (b) typically has a molecular weight less than 1,000, alternatively less than 750, alternatively less than 500. The organosilicon compound (b) further includes silicon-bonded organic groups that may be selected from the group of hydrocarbyl groups and halogen-substituted hydrocarbyl groups, both free of aliphatic unsaturation, which are as described and exemplified above for R¹.

Organosilicon compound (b) can be an organohydrogensilane or an organohydrogensiloxane, each of which are defined and exemplified in detail above.

Organosilicon compound (b) can be a single organosilicon compound or a mixture comprising two or more different organosilicon compounds, each as described above. For example, organosilicon compound (B) can be a single organohydrogensilane, a mixture of two different organohydrogensilanes, a single organohydrogensiloxane, a mixture of two different organohydrogensiloxanes, or a mixture of an organohydrogensilane and an organohydrogensiloxane. The mole ratio of silicon-bonded hydrogen atoms in organosilicon compound (b) to alkenyl groups in silicone resin (a) is typically from 1.5 to 5, alternatively from 1.75 to 3, alternatively from 2 to 2.5.

Hydrosilylation catalyst (c) can be any of the well-known hydrosilylation catalysts comprising a platinum group metal (i.e., platinum, rhodium, ruthenium, palladium, osmium and iridium) or a. compound containing a platinum group metal. Typically, the platinum group metal is platinum, based on its high activity in hydrosilylation reactions.

Specific hydrosilylation catalysts suitable for (c) include the complexes of chloroplatinic acid and certain vinyl-containing organosiloxanes disclosed by Willing in U.S. Pat. No. 3,419,593, the portions of which address hydrosilylation catalysts are hereby incorporated by reference. A catalyst of this type is the reaction product of chloroplatinic acid and 1,3-diethenyl-1,1,3,3-tetramethyldisiloxane.

The hydrosilylation catalyst can also be a supported hydrosilylation catalyst comprising a solid support having a platinum group metal on the surface thereof. A supported catalyst can be conveniently separated from the organohydrogenpolysiloxane resin represented by formula (IV), for example, by filtering the reaction mixture. Examples of supported catalysts include, but are not limited to, platinum on carbon, palladium on carbon, ruthenium on carbon, rhodium on carbon, platinum on silica, palladium on silica, platinum on alumina, palladium on alumina, and ruthenium on alumina.

The concentration of hydrosilylation catalyst (c) is sufficient to catalyze the addition reaction of silicone resin (a) with organosilicon compound (b). Typically, the concentration of hydrosilylation catalyst (c) is sufficient to provide from 0.1 to 1000 ppm of a platinum group metal, alternatively from 1 to 500 ppm of a platinum group metal, alternatively from 5 to 150 ppm of a platinum group metal, based on the combined weight of silicone resin (a) and organosilicon compound (b). The rate of reaction is very slow below 0.1 ppm of platinum group metal. The use of more than 1000 ppm of platinum group metal results in no appreciable increase in reaction rate, and is therefore uneconomical.

Organic solvent (d) includes at least one organic solvent. The organic solvent (d) can be any aprotic or dipolar aprotic organic solvent that does not react with silicone resin (a), organosilicon compound (b), or the resulting organohydrogenpolysiloxane resin under the conditions of the present method, and is miscible with components (a), (b), and the organohydrogenpolysiloxane resin.

Examples of organic solvents (d) that are suitable for purposes of the present invention include, but are not limited to, saturated aliphatic hydrocarbons such as n-pentane, hexane, n-heptane, isooctane and dodecane; cycloaliphatic hydrocarbons such as cyclopentane and cyclohexane; aromatic hydrocarbons such as benzene, toluene, xylene and mesitylene; cyclic ethers such as tetrahydrofuran (THF) and dioxane; ketones such as methyl isobutyl ketone (MIBK); halogenated alkanes such as trichloroethane; and halogenated aromatic hydrocarbons such as bromobenzene and chlorobenzene. Organic solvent (d) can be a single organic solvent or a mixture comprising two or more different organic solvents, each as described above. The concentration of organic solvent (d) is typically from 0 to 99% (w/w), alternatively from 30 to 80% (w/w), alternatively from 45 to 60% (w/w), based on the total weight of the reaction mixture.

The reaction to form the organohydrogenpolysiloxane resin represented by formula (IV) can be carried out in any standard reactor suitable for hydrosilylation reactions. Suitable reactors include glass and Teflon-lined glass reactors. Typically, the reactor is equipped with a means of agitation, such as stirring. Also, typically, the reaction is carried out in an inert atmosphere, such as nitrogen or argon, in the absence of moisture.

The silicone resin (a), organosilicon compound (b), hydrosilylation catalyst (c), and, optionally, organic solvent (d), can be combined in any order. Typically, organosilicon compound (b) and hydrosilylation catalyst (c) are combined before the introduction of the silicone resin (a) and, optionally, organic solvent (d). The reaction is typically carried out at a temperature of from 0 to 150 °C, alternatively from room temperature (∼23 ± 2 °C) to 115 °C. When the temperature is less than 0 °C, the rate of reaction is typically very slow. The reaction time depends on several factors, such as the structures of the silicone resin (a) and the organosilicon compound (b), and the temperature. The time of reaction is typically from 1 to 24 h at a temperature of from room temperature (∼23 ± 2 °C) to 150 °C. The optimum reaction time can be determined by routine experimentation.

The organohydrogenpolysiloxane resin represented by formula (IV) can be used without isolation or purification or the organohydrogenpolysiloxane resin can be separated from most of the organic solvent (d) by conventional methods of evaporation. For example, the reaction mixture can be heated under reduced pressure. Moreover, when the hydrosilylation catalyst (c) is a supported catalyst, as described above, the organohydrogenpolysiloxane resin can be readily separated from the hydrosilylation catalyst (c) by filtering the reaction mixture. However, the hydrosilylation catalyst may remain mixed with the organohydrogenpolysiloxane resin and be used as hydrosilylation catalyst (C).

The cross-linking agent (B) can be a single organosilicon compound or a mixture comprising two or more different organosilicon compounds, each as described above. For example, the cross-linking agent (B) can be a single organohydrogensilane, a mixture of two different organohydrogensilanes, a single organohydrogensiloxane, a mixture of two different organohydrogensiloxanes, or a mixture of an organohydrogensilane and an organohydrogensiloxane. In particular, the cross-linking agent (B) can be a mixture comprising the organohydrogenpolysiloxane resin having the formula (IV) in an amount of at least 0.5% (w/w), alternatively at least 50% (w/w), alternatively at least 75% (w/w), based on the total weight of the cross-linking agent (B), with the cross-linking agent (B) further comprising an organohydrogensilane and/or organohydrogensiloxane, the latter different from the organohydrogenpolysiloxane resin.

The concentration of cross-linking agent (B) is sufficient to cure (cross-link) the silicone resin (A). The exact amount of cross-linking agent (B) depends on the desired extent of cure. The concentration of cross-linking agent (B) is typically sufficient to provide from 0.4 to 2 moles of silicon-bonded hydrogen atoms, alternatively from 0.8 to 1.5 moles of silicon-bonded hydrogen atoms, alternatively from 0.9 to 1.1 moles of silicon-bonded hydrogen atoms, per mole of alkenyl groups in silicone resin (A).

Hydrosilylation catalyst (C) includes at least one hydrosilylation catalyst that promotes the reaction between silicone resin (A) and cross-linking agent (B). In one embodiment, the hydrosilylation catalyst (C) may be the same as the hydrosilylation catalyst (c) described above for producing the organohydrogenpolysiloxane resin. In addition, the hydrosilylation catalyst (C) can also be a microencapsulated platinum group metal-containing catalyst comprising a platinum group metal encapsulated in a thermoplastic resin. Hydrosilylation-curable silicone compositions including microencapsulated hydrosilylation catalysts are stable for extended periods of time, typically several months or longer, under ambient conditions, yet cure relatively rapidly at temperatures above the melting or softening point of the thermoplastic resin(s). Microencapsulated hydrosilylation catalysts and methods of preparing them are well known in the art, as exemplified in U.S. Pat. No. 4,766,176 and the references cited therein, and U.S. Pat. No. 5,017,654. The hydrosilylation catalyst (C) can be a single catalyst or a mixture comprising two or more different catalysts that differ in at least one property, such as structure, form, platinum group metal, complexing ligand, and thermoplastic resin.

In another embodiment, the hydrosilylation catalyst (C) may be at least one photoactivated hydrosilylation catalyst. The photoactivated hydrosilylation catalyst can be any hydrosilylation catalyst capable of catalyzing the hydrosilylation of the silicone resin (A) and the cross-linking agent (B) upon exposure to radiation having a wavelength of from 150 to 800 nm. The photoactivated hydrosilylation catalyst can be any of the well-known hydrosilylation catalysts comprising a platinum group metal or a compound containing a platinum group metal. The platinum group metals include platinum, rhodium, ruthenium, palladium, osmium, and iridium. Typically, the platinum group metal is platinum, based on its high activity in hydrosilylation reactions. The suitability of particular photoactivated hydrosilylation catalysts for use in the silicone composition of the present invention can be readily determined by routine experimentation.

Specific examples of photoactivated hydrosilylation catalysts suitable for purposes of the present invention include, but are not limited to, platinum(II) β-diketonate complexes such as platinum(II) bis(2,4-pentanedioate), platinum(II) bis(2,4-hexanedioate), platinum(II) bis(2,4-heptanedioate), platinum(II) bis(1-phenyl-1,3-butanedioate, platinum(II) bis(1,3-diphenyl-1,3-propanedioate), platinum(II) bis(1,1,1,5,5,5-hexafluoro-2,4-pentanedioate); (η-cyclopentadienyl)trialkylplatinum complexes, such as (Cp)trimethylplatinum, (Cp)ethyldimethylplatinum, (Cp)triethylplatinum, (chloro-Cp)trimethylplatinum, and (trimethylsilyl-Cp)trimethylplatinum, where Cp represents cyclopentadienyl; triazene oxide-transition metal complexes, such as Pt[C₆H₅NNNOCH₃]₄, Pt[p-CN-C₆H₄NNNOC₆H₁₁]₄, Pt[p-H₃COC₆H₄NNNOC₆H₁₁]₄, Pt[p-CH₃(CH₂)ₓ-C₆H₄NNNOCH₃]₄, 1,5-cyclooctadiene.Pt[p-CN-C₆H₄NNNOC₆H₁₁]₂, 1,5-cyclooctadiene.Pt[p-CH₃O-C₆H₄NNNOCH₃]₂, [(C₆H₅)₃P]₃Rh[p-CN-C₆H₄NNNOC₆H₁₁], and Pd[p-CH₃(CH₂)ₓ—C₆H₄NNNOCH₃]₂, where x is 1, 3, 5, 11, or 17; (η-diolefin)(σ-aryl)platinum complexes, such as (η⁴-1,5-cyclooctadienyl)diphenylplatinum, η⁴-1,3,5,7-cyclooctatetraenyl)diphenylplatinum, (η⁴-2,5-norboradienyl)diphenylplatinum, (η⁴-1,5-cyclooctadienyl)bis-(4-dimethylaminophenyl)platinum, (η⁴-1,5-cyclooctadienyl)bis-(4-acetylphenyl)platinum, and (η⁴-1,5-cyclooctadienyl)bis-(4-trifluormethylphenyl)platinum. Typically, the photoactivated hydrosilylation catalyst is a Pt(II) β-diketonate complex and more typically the catalyst is platinum(II) bis(2,4-pentanedioate). The hydrosilylation catalyst (C) can be a single photoactivated hydrosilylation catalyst or a mixture comprising two or more different photoactivated hydrosilylation catalysts.

Methods of preparing photoactivated hydrosilylation catalysts are well known in the art. For example, methods of preparing platinum(II) β-diketonates are reported by Guo et al. (Chemistry of Materials, 1998, 10, 531-536). Methods of preparing (η)-cyclopentadienyl)-trialkylplatinum complexes are disclosed in U.S. Patent No. 4,510,094. Methods of preparing triazene oxide-transition metal complexes are disclosed in U.S. Patent No. 5,496,961. Methods of preparing (η-diolefin)(σ-aryl)platinum complexes are taught in U.S. Patent No. 4,530,879.

The concentration of the hydrosilylation catalyst (C) is sufficient to catalyze the addition reaction of the silicone resin (A) and the cross-linking agent (B). The concentration of the hydrosilylation catalyst (C) is sufficient to provide typically from 0.1 to 1000 ppm of platinum group metal, alternatively from 0.5 to 100 ppm of platinum group metal, alternatively from 1 to 25 ppm of platinum group metal, based on the combined weight of the silicone resin (A) and the cross-linking agent (B).

Optionally, the hydrosilylation-curable silicone composition further includes (D) a silicone rubber having a formula selected from the group of (i) R¹R²₂SiO(R²₂SiO)ₐSiR²₂R¹ and (ii) R⁵R¹₂SiO(R¹R⁵SiO)_{b}SiR¹₂R⁵; wherein R¹ and R² are as defined and exemplified above, R⁵ is R¹ or -H, subscripts a and b each have a value of from 1 to 4, alternatively from 2 to 4, alternatively from 2 to 3, and w, x, y, and z are also as defined and exemplified above, provided the silicone resin and the silicone rubber (D)(i) each have an average of at least two silicon-bonded alkenyl groups per molecule, the silicone rubber (D)(ii) has an average of at least two silicon-bonded hydrogen atoms per molecule, and the mole ratio of silicon-bonded alkenyl groups or silicon-bonded hydrogen atoms in the silicone rubber (D) to silicon-bonded alkenyl groups in the silicone resin (A) is from 0.01 to 0.5.

Specific examples of silicone rubbers suitable for use as component (D)(i) include, but are not limited to, silicone rubbers having the following formulae:
ViMe₂SiO(Me₂SiO)ₐSiMe₂Vi, ViMe₂SiO(Ph₂SiO)ₐSiMe₂Vi, and ViMe₂SiO(PhMeSiO)ₐ SiMe₂Vi,
wherein Me is methyl, Ph is phenyl, Vi is vinyl, and the subscript a has a value of from 1 to 4. Silicone rubber (D)(i) can be a single silicone rubber or a mixture comprising two or more different silicone rubbers that each satisfy the formula for (D)(i).

Specific examples of silicone rubbers suitable for use as silicone rubber (D)(ii) include, but are not limited to, silicone rubbers having the following formulae:
HMe₂SiO(Me₂SiO)_{b}SiMe₂H, HMe₂SiO(Ph₂SiO)_{b}SiMe₂H, HMe₂SiO(PhMeSiO)_{b} SiMe₂H, and HMe₂SiO(Ph₂SiO)₂(Me₂SiO)₂SiMe₂H,
wherein Me is methyl, Ph is phenyl, and the subscript b has a value of from 1 to 4. Component (D)(ii) can be a single silicone rubber or a mixture comprising two or more different silicone rubbers that each satisfy the formula for (D)(ii).

The mole ratio of silicon-bonded alkenyl groups or silicon-bonded hydrogen atoms in the silicone rubber (D) to silicon-bonded alkenyl groups in the silicone resin (A) is typically from 0.01 to 0.5, alternatively from 0.05 to 0.4, alternatively from 0.1 to 0.3.

When the silicone rubber (D) is (D)(i), the concentration of the cross-linking agent (B) is such that the ratio of the number of moles of silicon-bonded hydrogen atoms in the cross-linking agent (B) to the sum of the number of moles of silicon-bonded alkenyl groups in the silicone resin (A) and the silicone rubber (D)(i) is typically from 0.4 to 2, alternatively from 0.8 to 1.5, alternatively from 0.9 to 1.1. Furthermore, when the silicone rubber (D) is (D)(ii), the concentration of the cross-linking agent (B) is such that the ratio of the sum of the number of moles of silicon-bonded hydrogen atoms in the cross-linking agent (B) and the silicone rubber (D)(ii) to the number of moles of silicon-bonded alkenyl groups in the silicone resin (A) is typically from 0.4 to 2, alternatively from 0.8 to 1.5, alternatively from 0.9 to 1.1.

Methods of preparing silicone rubbers containing silicon-bonded alkenyl groups or silicon-bonded hydrogen atoms are well known in the art; many of these compounds are commercially available. [0067] In another embodiment of the present invention, the hydrosilylation-curable silicone composition comprises (A¹) a rubber-modified silicone resin prepared by reacting the silicone resin (A) and at least one silicone rubber (D)(iii) selected from rubbers having the following formulae:

R⁵R¹₂SiO(R¹R⁵SiO)_{c}SiR¹₂R⁵,

and

R¹R²₂SiO(R²₂SiO)_{d}SiR²₂R¹,

wherein R¹ and R⁵ are as defined and exemplified above and c and d each have a value of from 4 to 1000, alternatively from 10 to 500, alternatively from 10 to 50, in the presence of the hydrosilylation catalyst (c) and, optionally, an organic solvent, provided the silicone resin (A) has an average of at least two silicon-bonded alkenyl groups per molecule, the silicone rubber (D)(iii) has an average of at least two silicon-bonded hydrogen atoms per molecule, and the mole ratio of silicon-bonded hydrogen atoms in the silicone rubber (D)(iii) to silicon-bonded alkenyl groups in silicone resin (A) is from 0.01 to 0.5. By "at least one silicone rubber", it is meant that only one of the rubbers represented by the formulae are necessary for (D)(iii), and that combinations of the rubbers represented by the formulae may be used. When organic solvent is present, the rubber-modified silicone resin (A¹) is miscible in the organic solvent and does not form a precipitate or suspension.

The silicone resin (A), silicone rubber (D)(iii), hydrosilylation catalyst (c), and organic solvent can be combined in any order. Typically, the silicone resin (A), silicone rubber (D)(iii), and organic solvent are combined before the introduction of the hydrosilylation catalyst (c).

The reaction is typically carried out at a temperature of from room temperature (∼23 ± 2 °C) to 150 °C, alternatively from room temperature to 100 °C. The reaction time depends on several factors, including the structures of the silicone resin (A) and the silicone rubber (D)(iii) and the temperature. The components are typically allowed to react for a period of time sufficient to complete the hydrosilylation reaction. This means the components are typically allowed to react until at least 95 mol%, alternatively at least 98 mol%, alternatively at least 99 mol%, of the silicon-bonded hydrogen atoms originally present in the silicone rubber (D)(iii) have been consumed in the hydrosilylation reaction, as determined by FTIR spectrometry. The time of reaction is typically from 0.5 to 24 h at a temperature of from room temperature (∼23 ± 2 °C) to 100 °C. The optimum reaction time can be determined by routine experimentation.

The mole ratio of silicon-bonded hydrogen atoms in the silicone rubber (D)(iii) to silicon-bonded alkenyl groups in the silicone resin (A) is typically from 0.01 to 0.5, alternatively from 0.05 to 0.4, alternatively from 0.1 to 0.3.

The concentration of the hydrosilylation catalyst (c) is sufficient to catalyze the addition reaction of the silicone resin (A) with the silicone rubber (D)(iii). Typically, the concentration of the hydrosilylation catalyst (c) is sufficient to provide from 0.1 to 1000 ppm of a platinum group metal, based on the combined weight of the resin and the rubber.

The concentration of the organic solvent is typically from 0 to 95% (w/w), alternatively from 10 to 75% (w/w), alternatively from 40 to 60% (w/w), based on the total weight of the reaction mixture.

The rubber-modified silicone resin (A1) can be used without isolation or purification, or the rubber-modified silicone resin (A¹) can be separated from most of the solvent by conventional methods of evaporation. For example, the reaction mixture can be heated under reduced pressure. Moreover, when the hydrosilylation catalyst (c) is a supported catalyst, described above, the rubber-modified silicone resin (A¹) can be readily separated from the hydrosilylation catalyst (c) by filtering the reaction mixture. However, when the rubber-modified silicone resin (A¹) is not separated from the hydrosilylation catalyst (c) used to prepare the rubber-modified silicone resin (A¹), the hydrosilylation catalyst (c) may be used as the hydrosilylation catalyst (C).

The hydrosilylation-curable silicone composition of the present invention can comprise additional ingredients, as known in the art. Examples of additional ingredients include, but are not limited to, hydrosilylation catalyst inhibitors, such as 3-methyl-3-penten-1-yne, 3,5-dimethyl-3-hexen-1-yne, 3,5-dimethyl-1-hexyn-3-ol, 1-ethynyl-1-cyclohexanol, 2-phenyl-3-butyn-2-ol, vinylcyclosiloxanes, and triphenylphosphine; adhesion promoters, such as the adhesion promoters taught in U.S. Patent Nos. 4,087,585 and 5,194,649; dyes; pigments; anti-oxidants; heat stabilizers; UV stabilizers; flame retardants; flow control additives; and diluents, such as organic solvents and reactive diluents.

As an alternative to the hydrosilylation-curable silicone composition, condensation-curable silicone compositions are also suitable for the silicone composition of the present invention.

The condensation-curable silicone composition typically includes a silicone resin (A²) having silicon-bonded hydrogen atoms, silicon-bonded hydroxy groups, or silicon-bonded hydrolysable groups, optionally, a cross-linking agent (B¹) having silicon-bonded hydrolysable groups and, optionally, a condensation catalyst (C¹). The condensation curable silicone resin (A²) is typically a copolymer comprising R¹SiO_{3/2} units, i.e., T units, and/or SiO_{4/2} units, i.e., Q units, in combination with R¹R⁶2SiO_{1/2} units, i.e., M units, and/or R⁶₂SiO_{2/2} units, i.e., D units, wherein R¹ is set forth above, R⁶ is R¹, -H, -OH, or a hydrolysable group. For example, the silicone resin can be a DT resin, an MT resin, an MDT resin, a DTQ resin, an MTQ resin, an MDTQ resin, a DQ resin, an MQ resin, a DTQ resin, an MTQ resin, or an MDQ resin.

According to one embodiment, the silicone resin (A²) has the formula:

(R¹R⁶₂SiO_{1/2})_{w'}(R⁶₂SiO_{2/2})_{x'}(R⁶SiO_{3/2})y_{'}(SiO_{4/2})_{z'} (V)

wherein R¹ and R⁶ are defined and exemplified above, w' is from 0 to 0.8, alternatively from 0.02 to 0.75, alternatively from 0.05 to 0.3, x' is from 0 to 0.95, alternatively from 0.05 to 0.8, alternatively from 0.1 to 0.3, y' is from 0 to 1, alternatively from 0.25 to 0.8, alternatively from 0.5 to 0.8, and z' is from 0 to 0.99, alternatively from 0.2 to 0.8, alternatively from 0.4 to 0.6. The silicone resin (A²) has an average of at least two silicon-bonded hydrogen atoms, hydroxy groups, or hydrolysable groups per molecule. As used herein the term "hydrolysable group" means the silicon-bonded group reacts with water in the absence of a catalyst at any temperature from room temperature (∼23=± 2 °C) to 100 °C within several minutes, for example thirty minutes, to form a silanol (Si-OH) group. Examples of hydrolysable groups represented by R⁶ include, but are not limited to, -C1, -Br, -OR⁷, -OCH₂CH₂OR⁷, CH₃C(=O)O-, Et(Me)C=N-O-, CH₃C(=O)N(CH₃)-, and -ONH₂, wherein R⁷ is C₁ to C₈ hydrocarbyl or C₁ to C₈ halogen-substituted hydrocarbyl.

The hydrocarbyl and halogen-substituted hydrocarbyl groups represented by R⁷ typically have from 1 to 8 carbon atoms, alternatively from 3 to 6 carbon atoms. Acyclic hydrocarbyl and halogen-substituted hydrocarbyl groups containing at least 3 carbon atoms can have a branched or unbranched structure. Examples of hydrocarbyl groups represented by R⁷ include, but are not limited to, unbranched and branched alkyl, such as methyl, ethyl, propyl, 1-methylethyl, butyl, 1-methylpropyl, 2-methylpropyl, 1,1-dimethylethyl, pentyl, 1-methylbutyl, 1-ethylpropyl, 2-methylbutyl, 3-methylbutyl, 1,2-dimethylpropyl, 2,2-dimethylpropyl, hexyl, heptyl, and octyl; cycloalkyl, such as cyclopentyl, cyclohexyl, and methylcyclohexyl; phenyl; alkaryl, such as tolyl and xylyl; aralkyl, such as benzyl and phenethyl; alkenyl, such as vinyl, allyl, and propenyl; arylalkenyl, such as styryl; and alkynyl, such as ethynyl and propynyl. Examples of halogen-substituted hydrocarbyl groups represented by R⁷ include, but are not limited to, 3,3,3-trifluoropropyl, 3-chloropropyl, chlorophenyl, and dichlorophenyl.

Typically, at least 1 mol%, alternatively at least 5 mol%, alternatively at least 10 mol% of the groups R⁶ in the silicone resin (A²) are hydrogen, hydroxy, or a hydrolysable group. As used herein, the mol% of groups in R⁶ is defined as a ratio of the number of moles of silicon-bonded groups in the silicone resin (A²) to the total number of moles of the R⁶ groups in the silicone resin (A²), multiplied by 100.

Specific examples of cured silicone resins formed from silicone resin (A²) include, but are not limited to, cured silicone resins having the following formulae:
(MeSiO_{3/2})_{0.9}(Me(HO)SiO_{2/2})₀.₁, (phSiO_{3/2})₀.₇(Ph(MeO)SiO_{2/2})₀.₃,
(Me₃SiO_{1/2})₀.₈(SiO_{4/2})₀.₁₅ (HOSiO_{3/2})_{0.05},
(MeSiO_{3/2})_{0.67}(PhSiO_{3/2})₀.₂₃(Ph(HO)SiO_{2/2})₀.₁,
(MeSiO_{3/2})₀.₄₅(PhSiO_{3/2})₀.₂₄(Ph(HO)SiO_{2/2})₀.₁₆(Ph₂SiO_{2/2})_{0.16} (PhMeSiO_{2/2})_{0.1}(PhMeSiO_{2/2})0. 05,
(PhSiO_{3/2})₀.₃(Ph(HO)SiO_{2/2})₀.₁(MeSiO_{3/2})₀.₄(Me(HO)SiO_{2/2})_{0.05}(PhSiO_{3/2})0.1 (PhMeSiO_{2/2})_{0.05}, and
(PhSiO_{3/2})0.3(Ph(MeO)SiO_{2/2})_{0.1} (MeSiO_{3/2})0.1 (PhMeSiO_{2/2})_{0.5,}
wherein Me is methyl, Ph is phenyl, the numerical subscripts outside the parenthesis denote mole fractions, and the subscript n has a value such that the silicone resin typically has a number-average molecular weight of from 500 to 50,000. The sequence of units in the preceding formulae is not to be viewed in any way as limiting to the scope of the invention.

As set forth above, the silicone resin (A²) represented by formula (V) typically has a number-average molecular weight (Mₙ) of from 500 to 50,000. Alternatively, the silicone resin (A²) may have a Mₙ of at least 300, alternatively 1,000 to 3,000, where the molecular weight is determined by gel permeation chromatography employing a low angle laser light scattering detector, or a refractive index detector and silicone resin (MQ) standards.

The viscosity of the silicone resin (A²) at 25 °C is typically from 0.01 Pa-s to solid, alternatively from 0.1 to 100,000 Pa-s, alternatively from 1 to 1,000 Pa-s.

In a second embodiment, the silicone resin (A²) can have the same formula (V) as set forth above, but with different values for the subscripts x and z and with the proviso that the sum of R⁶SiO_{3/2} units and SiO_{4/2} units is greater than zero and with the further proviso that the silicone resin (A²) of the second embodiment contains at least two silicon-bonded hydrogen atoms, at least two silicon-bonded hydroxy groups, or at least two silicon-bonded hydrolysable groups per molecule. More specifically, for the silicone resin (A²) of the second embodiment, w', y', R¹, and R⁶ remain the same as set forth above, x' typically has a value of from 0 to 0.6, alternatively from 0 to 0.45, alternatively from 0 to 0.25, z' typically has a value of from 0 to 0.35, alternatively from 0 to 0.25, alternatively from 0 to 0.15, and the sum of y'+z' is greater than zero and is typically from 0.2 to 0.99, alternatively from 0.5 to 0.95, alternatively from 0.65 to 0.9. Further, the sum of w'+x' can be zero but is typically from 0.01 to 0.80, alternatively from 0.05 to 0.5, alternatively from 0.1 to 0.35. Typically, 1 mol% to 30 mol%, alternatively 1 to 15 mol%, of the R⁶ groups in the silicone resin (A²) of the second embodiment are hydrogen, hydroxy, or a hydrolysable group.

Examples of condensation curable silicone resins (A²) of the second embodiment include, but are not limited to, silicone resins having the following formulae:
(Me(MeO)Si_{2/2})_{x'}(McSiO_{3/2})y_{'}, (Ph(HO)SiO_{2/2})_{x'}(PhSiO_{3/2})y_{'}, (Me₃SiO_{1/2})_{w'}(CH₃COOSiO_{3/2})y_{'}(SiO_{4/2})_{z'},
(Ph(MeO)SiO_{2/2}))_{x'}(MeSiO_{3/2})_{y'},(PhSiO_{3/2})_{y'},
(Ph(MeO)(HO)SiO_{1/2})_{w'}(MeSiO_{3/2})_{y'}(PhSiO_{3/2})_{y'}(Ph₂SiO_{2/2})_{x'}(PhMeSiO_{2/2})_{x'}, (PhMe(MeO)SiO_{1/2})_{w'}(Ph(HO)SiO_{2/2})_{x'}(MeSiO_{3/2})_{y'}(PhSiO_{3/2})_{y'}(PhMeSiO_{2/2})_{x'} and (Ph(HO)SiO_{2/2})_{x'}(PhSiO_{3/2})_{y'}(MeSiO_{3/2})_{y'}(PhMeSiO_{2/2})_{x'}
wherein Me is methyl, Ph is phenyl, wherein w', x', y', and z' are as defined above, and the subscript y' has a value such that the silicone resin has a number-average molecular weight of from 500 to 50,000. The sequence of units in the preceding formulae is not to be viewed in any way as limiting to the scope of the invention.

Specific examples of condensation curable silicone resins (A²) of the second embodiment include, but are not limited to, silicone resins having the following formulae:
(Me(MeO)Si_{2/2})₀.₀₅(Me₃SiO_{1/2})₀.₇₅(SiO_{4/2})0.2,
(Ph(HO)SiO_{2/2})₀.₀₉(MeSiO_{3/2})₀.₆₇(PhSiO_{3/2})_{0.24,}
(Ph(MeO)SiO_{2/2})_{0.05}(MeSiO_{3/2})₀.₄₅(PhSiO_{3/2})_{0.35}(Ph₂SiO_{2/2})₀.₁(PhMeSiO_{2/2}) 0.05,
(PhMe(MeO)SiO_{1/2})_{0.02}(PhSiO_{3/2})_{0.4}(MeSiO_{3/2})_{0.45}(PhSiO_{3/2})_{0.1}(PhMeSiO_{2/2}) 0.03, and
(Ph(HO)SiO_{2/2})₀.₀₄(PhMe(MeO)SiOi_{/2})o_{.03}(PhSi0_{3/2})o.₃₆(MeSi0_{3/2})o.ₗ(PhMe SiO_{2/2})₀.₄₇
wherein Me is methyl, Ph is phenyl, and the numerical subscripts outside the parenthesis denote mole fractions. The sequence of units in the preceding formulae is not to be viewed in any way as limiting to the scope of the invention.

As set forth above, the condensation curable silicone resin (A²) of the second embodiment typically has a number-average molecular weight (Mₙ) of from 500 to 50,000. Alternatively, the condensation curable silicone resin (A) may have a Mₙ of from 500 to 10,000, alternatively 800 to 3,000, where the molecular weight is determined by gel permeation chromatography employing a refractive index detector and silicone resin (MQ) standards.

The viscosity of the condensation curable silicone resin (A²) of the second embodiment at 25 °C is typically from 0.01 Pa-s to a solid, alternatively from 0.1 to 10,000 Pa-s, alternatively from 1 to 100 Pa·s. The condensation curable silicone resin (A) represented by formula (V) typically includes less than 20% (w/w), alternatively less than 10% (w/w), alternatively less than 2% (w/w), of silicon-bonded hydroxy groups, as determined by ²⁹Si NMR.

Methods of preparing silicone resins (A²) represented by formula (V) are well known in the art; many of these resins are commercially available. Silicone resins (A²) represented by formula (V) are typically prepared by cohydrolyzing the appropriate mixture of chlorosilane precursors in an organic solvent, such as toluene. For example, a silicone resin including R¹R⁶₂SiO_{1/2} units and R⁶SiO_{3/2} units can be prepared by cohydrolyzing a first compound having the formula R¹R⁶₂SiCl and a second compound having the formula R⁶SiCl₃ in toluene, where R¹ and R⁶ are as defined and exemplified above. The cohydrolyzing process is described above in terms of the hydrosilylation-curable silicone composition. The cohydrolyzed reactants can be further "bodied" to a desired extent to control the amount of crosslinkable groups and viscosity.

If desired, the silicone resins (A²) represented by formula (V) can be further treated with a condensation catalyst in an organic solvent to reduce the content of silicon-bonded hydroxy groups. Alternatively, first or second compounds containing hydrolysable groups other than chloro groups, such -Br, -I, -OCH₃, -OC(O)CH₃, - N(CH₃)₂, NHCOCH₃, and -SCH₃, can be co-hydrolyzed to form the silicone resin (A²). The properties of the silicone resin (A²) depend on the types of first and second compounds, the mole ratio of first and second compounds, the degree of condensation, and the processing conditions.

The Q units in formula (V) can be in the form of discrete particles in the silicone resin (A²). The particle size is typically from 1 nm to 20 µm. Examples of these particles include, but are not limited to, silica (SiO_{4/2}) particles of 15 nm in diameter.

In another embodiment, the condensation-curable silicone composition comprises a rubber-modified silicone resin (A³) prepared by reacting an organosilicon compound selected from (i) a silicone resin having the formula (R¹R⁶₂SiO_{1/2})_{w}'(R⁶₂SiO_{2/2})_{x'}(R⁶SiO_{3/2})_{y'}(SiO_{4/2})_{z'}, (ii) hydrolysable precursors of (i), and (iii) a silicone rubber having the formula R⁸₃SiO(R¹R⁸SiO)ₘSiR⁸₃ in the presence of water, (iv) a condensation catalyst, and (v) an organic solvent, wherein R¹ and R⁶ are as defined and exemplified above, R⁸ is R¹ or a hydrolysable group, m is from 2 to 1,000, alternatively from 4 to 500, alternatively from 8 to 400, and w', x', y', and z' are as defined and exemplified above. Silicone resin (i) has an average of at least two silicon-bonded hydroxy or hydrolysable groups per molecule. The silicone rubber (iii) has an average of at least two silicon-bonded hydrolysable groups per molecule. The mole ratio of silicon-bonded hydrolysable groups in the silicone rubber (iii) to silicon-bonded hydroxy or hydrolysable groups in the silicone resin (i) is from 0.01 to 1.5, alternatively from 0.05 to 0.8, alternatively from 0.2 to 0.5.

In a first embodiment, typically at least 1 mol%, alternatively at least 5 mol%, alternatively at least 10 mol% of the groups R⁶ in the silicone resin (i) are hydroxy or hydrolysable groups. In a second embodiment, typically 1 mol% to 30 mol%, or alternatively 1 to 15 mol% of the groups R⁶ in the silicone resin (i) are hydrogen, hydroxy, or a hydrolysable group.

The silicone resin (i) of the first embodiment typically has a number-average molecular weight (Mₙ) of at least 300, alternatively from 500 to 50,000, alternatively from 800 to 3,000, where the molecular weight is determined by gel permeation chromatography employing a low angle laser light scattering detector, or a refractive index detector and silicone resin (MQ) standards.

Specific examples of silicone resins suitable for use as silicone resin (i) include, but are not limited to, resins having the following formulae:
(Me(MeO)Si_{2/2})_{x'}(MeSiO_{3/2})_{y'}, (Ph(HO)SiO_{2/2})_{x'}(PhSiO_{3/2})_{y}',
(Ph(MeO)SiO_{2/2})_{x'}(PhSiO_{3/2})_{y'}(MeSiO_{3/2})_{y'}(PhSiO_{3/2})_{y}'(PhMeSiO_{2/2})ₓ', and
(CH₃COOSiO_{3/2})_{y'}(PhSiO_{3/2})_{y'}(SiO_{4/2})_{z'}(Me₂SiO_{2/2})_{x'}(Ph₂SiO_{2/2})_{x'}
where Me is methyl, Ph is phenyl, where x', y', and z' are as defined above, and the subscript y' has a value such that the silicone resin has a number-average molecular weight of from 500 to 50,000. The sequence of units in the preceding formulae is not to be viewed in any way as limiting to the scope of the invention.

Other specific examples of silicone resins suitable for use as silicone resin (i) include, but are not limited to, resins having the following formulae:
(Ph(HO)SiO_{2/2})₀.₀₃(PhSiO_{3/2})₀.₃₇(MeSiO_{3/2})₀.₄₅(PhSiO_{3/2})_{0.1}(PhMeSiO_{2/2})_{0.0} 5 and
(CH₃COOSiO_{3/2})₀.₀₆(PhSiO_{3/2})₀.₃(SiO_{4/2})₀.₀₄(Me₂SiO_{2/2})0.2(Ph₂SiO_{2/2})0.4
where Me is methyl, Ph is phenyl, the numerical subscripts outside the parenthesis denote mole fractions. The sequence of units in the preceding formulae is not to be viewed in any way as limiting to the scope of the invention. Silicone resin (i) can be a single silicone resin or a mixture comprising two or more different silicone resins, each having the specified formula. Silicone resin (i) can be a single silicone resin or a mixture comprising two or more different silicone resins, each having the specified formula.

As used herein, the term "hydrolysable precursors" refers to silanes having hydrolysable groups that are suitable for use as starting materials (precursors) for preparation of the silicone resin (i). The hydrolysable precursors (ii) can be represented by the formulae R¹R⁸₂SiX, R⁸₂SiX₂, R⁸SiX₃, and SiX₄, wherein R¹, R⁸, and X are as defined and exemplified above.

Specific examples of hydrolysable precursors (ii) include, but are not limited to, silanes having the formulae:
Me₂ViSiCl, Me₃SiCl, MeSi(OEt)₃, PhSiCl₃, MeSiCl₃, Me₂SiCl₂, PhMeSiCl₂, SiC1₄, ^{.}Ph₂SiCl₂, PhSi(OMe)₃, MeSi(OMe)₃, PhMeSi(OMe)₂, and Si(OEt)₄,
wherein Me is methyl, Et is ethyl, and Ph is phenyl.

Specific examples of silicone rubbers (iii) include, but are not limited to, silicone rubbers having the following formulae:
(EtO)₃SiO(Me₂SiO)₅₅Si(OEt)₃, (EtO)₃SiO(Me₂SiO)₁₆Si(OEt)₃, (EtO)₃SiO(Me₂SiO)₃₈₆Si(OEt)₃, and (EtO)₂MeSiO(PhMeSiO)₁₀SiMe(OEt)₂,
wherein Me is methyl and Et is ethyl.

The reaction is typically carried out at a temperature of from room temperature (-23 ± 2 °C) to 180°C, alternatively from room temperature to 100 °C.

The reaction time depends on several factors, including the structures of the silicone resin (i) and the silicone rubber (iii), and the temperature. The components are typically allowed to react for a period of time sufficient to complete the condensation reaction. This means the components are allowed to react until at least 40 mol%, alternatively at least 65 mol%, alternatively at least 90 mol%, of the silicon-bonded hydrolysable groups originally present in the silicone rubber (iii) have been consumed in the condensation reaction, as determined by ²⁹Si NMR spectrometry. The time of reaction is typically from 1 to 30 h at a temperature of from room temperature (∼23 ± 2 °C) to 100 °C. The optimum reaction time can be determined by routine experimentation.

Suitable condensation catalysts (iv) are described in further detail below, and suitable organic solvents (v) are described above in the context of rubber-modified silicone resin (A¹) above. The concentration of the condensation catalyst (iv) is sufficient to catalyze the condensation reaction of the silicone resin (i) with the silicone rubber (iii). Typically, the concentration of the condensation catalyst (iv) is from 0.01 to 5% (w/w), alternatively from 0.01 to 3% (w/w), alternatively from 0.05 to 2.5% (w/w), based on the weight of the silicon resin (i). The concentration of the organic solvent (v) is typically from 10 to 95% (w/w), alternatively from 20 to 85% (w/w), alternatively from 50 to 80% (w/w), based on the total weight of the reaction mixture.

The concentration of water in the reaction mixture depends on the nature of the groups R⁸ in the organosilicon compound and the nature of the silicon-bonded hydrolysable groups in the silicone rubber. When the silicone resin (i) contains hydrolysable groups, the concentration of water is sufficient to effect hydrolysis of the hydrolysable groups in the silicon resin (i) and the silicone rubber (iii). For example, the concentration of water is typically from 0.01 to 3 moles, alternatively from 0.05 to 1 moles, per mole of hydrolysable groups in the silicone resin (i) and the silicone rubber (iii) combined. When the silicone resin (i) does not contain hydrolysable groups, only a trace amount, e.g., 100 ppm, of water is typically present in the reaction mixture. Trace amounts of water are normally present in the reactants and/or solvent.

As set forth above, the condensation-curable silicone composition can further comprise the cross-linking agent (B¹). The cross-linking agent (B¹) can have the formula R⁷qSiX_{4-q}, wherein R⁷ is C₁ to C₈ hydrocarbyl or C₁ to C₈ halogen-substituted hydrocarbyl, X is a hydrolysable group, and q is 0 or 1. The hydrocarbyl and halogen-substituted hydrocarbyl groups represented by R⁷, and the hydrolysable groups represented by X, are as described and exemplified above.

Specific examples of cross-linking agents (B¹) include, but are not limited to, alkoxy silanes such as MeSi(OCH₃)₃, CH₃Si(OCH₂CH₃)₃, CH₃Si(OCH₂CH₂CH₃)₃, CH₃Si[O(CH₂)₃CH_{3]3}, CH₃CH₂Si(OCH₂CH₃)₃, C₆H₅Si(OCH₃)₃, C₆H₅CH₂Si(OCH₃)₃, C₆H₅Si(OCH₂CH₃)₃, CH₂=CHSi(OCH₃)₃, CH₂=CHCH₂Si(OCH₃)₃, CF₃CH₂CH₂Si(OCH₃)₃, CH₃Si(OCH₂CH₂OCH₃)₃, CF₃CH₂CH₂Si(OCH₂CH₂OCH₃)₃, CH₂=CHSi(OCH₂CH₂OCH₃)₃, CH₂=CHCH₂Si(OCH₂CH₂OCH₃)₃, C₆H₅Si(OCH₂CH₂OCH₃)3, Si(OCH₃)₄, Si(OC₂H₅)₄, and Si(OC₃H₇)₄; organoacetoxysilanes such as CH₃Si(OCOCH₃)₃, CH₃CH₂Si(OCOCH₃)₃, and CH₂=CHSi(OCOCH₃)3; organoiminooxysilanes such as CH₃Si[ON=C(CH₃)CH₂CH₃]₃, Si[O-N=C(CH₃)CH₂CH₃]₄, and CH₂=CHSi[ON=C(CH₃)CH₂CH₃]₃; organoacetamidosilanes such as CH₃Si[NHC(=O)CH₃]₃ and C₆H₅Si[NHC(=O)CH₃]₃; amino silanes such as CH₃Si[NH(s-C₄H₉)]₃ and CH₃Si(NHC₆H₁₁)₃; and organoaminooxysilanes.

The cross-linking agent (B¹) can be a single silane or a mixture of two or more different silanes, each as described above. Also, methods of preparing tri- and tetra-functional silanes are well known in the art; many of these silanes are commercially available.

When present, the concentration of the cross-linking agent (B¹) in the condensation-curable silicone composition is sufficient to cure (cross-link) the condensation-curable silicone resin. The exact amount of the cross-linking agent (B¹) depends on the desired extent of cure, which generally increases as the ratio of the number of moles of silicon-bonded hydrolysable groups in the cross-linking agent (B¹) to the number of moles of silicon-bonded hydrogen atoms, hydroxy groups, or hydrolysable groups in the silicone resin (A²) increases. Typically, the concentration of the cross-linking agent (B¹) is sufficient to provide from 0.2 to 4 moles of silicon-bonded hydrolysable groups per mole of silicon-bonded hydrogen atoms, hydroxy groups, or hydrolysable groups in the silicone resin (A²). The optimum amount of the cross-linking agent (B¹) can be readily determined by routine experimentation.

Condensation catalyst (C¹) can be any condensation catalyst typically used to promote condensation of silicon-bonded hydroxy (silanol) groups to form Si-O-Si linkages. Examples of condensation catalysts include, but are not limited to, amines; and complexes of lead, tin, zinc, and iron with carboxylic acids. In particular, the condensation catalyst (C¹) can be selected from tin(II) and tin(IV) compounds such as tin dilaurate, tin dioctoate, and tetrabutyl tin; and titanium compounds such as titanium tetrabutoxide.

When present, the concentration of the condensation catalyst (C¹) is typically from 0.1 to 10% (w/w), alternatively from 0.5 to 5% (w/w), alternatively from 1 to 3% (w/w), based on the total weight of the silicone resin (A²).

When the condensation-curable silicone composition includes the condensation catalyst (C¹), the condensation-curable silicone composition is typically a two-part composition where the silicone resin (A²) and condensation catalyst (C¹) are in separate parts.

The condensation-curable silicone composition can further contain inorganic fillers in particulate form, such as silica, alumina, calcium carbonate, and mica. In one embodiment, for example, the condensation-curable silicone composition further includes silica nanoparticles. The nanoparticles may help reduce the coefficient of thermal expansion of substrate **106**. A low coefficient of thermal expansion may improve manufacturability of CdTe-based photovoltaic devices **104**. Nanoparticles may also increase mechanical strength of substrate **106**. The silica nanoparticles can be any silica material having at least one physical dimension (e.g., particle diameter, layer thickness) less than about 200 nm. One particularly useful form of silica nanoparticles are fumed silica nanoparticles. Examples of useful commercially available unmodified silica starting materials include nano-sized colloidal silicas available under the product designations NALCO 1040, 1042, 1050, 1060, 2326, 2327, and 2329 colloidal silica from Nalco Chemical Co., Naperville, Illinois, Aerosil® from Degussa, Ludox® from DuPont, Snowtex® from Nissan Chemical, Levasil® from Bayer, or Sylysia® from Fuji Silysia Chemical. Suitable fumed silicas include for example, products commercially available from DeGussa AG, (Hanau, Germany) under the trade designation, "Aerosil series OX 50", as well as product numbers- 130,-15 0, and-200. Fumed silicas are also commercially available from Cabot Corp., Tuscola, I, under the Bade designations CAB O-SPERSE 2095", "CAB-O-SPERSE A105", and "CAB-O-SIL M5". Those skilled in the art are aware of different well-established processes to access particles in different sizes, with different physical properties and with different compositions such as flame-hydrolysis (Aerosil-Process), plasma-process, arc-process and hot-wall reactor-process for gas-phase or solid-phase reactions or ionic-exchange processes and precipitation processes for solution-based reactions.

The silica nanoparticles may be in the form of a colloidal dispersion. The silica nanoparticles thus may be dispersed in a polar solvent such as methanol, ethanol, isopropyl alcohol (IPA), ketones such as methyl isobutyl ketone, water, acetic acid, diols and trials such as propylene glycol, 2-methyl-1,3-propane diol HOCH2CH(CH3)CH2OH, 1,2-hexanediol CH3(CH2)3CH(OH)CH2OH, and glycerol; glycerol esters such as glyceryl triacetate (triacetin), glyceryl tripropionate (tripropionin), and glyceryl tributyrate (tributyrin); and polyglycols such as polyethylene glycols and polypropylene glycols, among which are PPG-14 butyl ether C₄Hg(OCH(CH₃)CH₂)₁₄OH. Alternatively, the silica nanoparticles can also be dispersed in a non-polar solvent such as toluene, benzene, xylene, etc.

The silica particle size typically ranges from 1 to 1000 nm, or alternatively from 1 to 100 nm, or alternatively from 5 to 30 nm. The silica nanoparticles can be a single type of silica nanoparticles or a mixture comprising at least two different types of silica nanoparticles. It is known that silica nanoparticles may be of pure silicon dioxide, or they may contain a certain amount of impurities such as Al₂O₃, ZnO, and/or cations such as Na⁺, K⁺⁺, Ca⁺⁺, Mg⁺⁺, etc.

The concentration of the silica nanoparticles is typically from 0.0001 to 99 wt%, alternatively from 0.001 to 75 wt%, alternatively from 10 to 65 wt%, alternatively from 5 to 50 wt%, alternatively from 20 to 40 wt%, based on the total weight of the condensation-curable silicone composition. The condensation-curable silicone composition can be a one-part composition comprising the condensation-curable silicone resin (A² or A³), and any optional ingredients, and silica nanoparticles in a single part or, alternatively, a multi-part composition comprising these components in two or more parts.

The one-part condensation-curable silicone composition can be prepared by combining the condensation curable silicone resin (A² or A³), the silica nanoparticles, and any optional ingredients in the stated proportions at ambient temperature, with or without the aid of an organic solvent. Also, the silicone composition can be prepared by combining the components in each part. The condensation-curable silicone compositions including the silica nanoparticles can also be prepared in-situ, i.e., the silica nanoparticles can be added during the process to manufacture the condensation-curable silicone resin (A² or A³) described above. Mixing can be accomplished by any of the techniques known in the art such as milling, blending, and stirring, either in a batch or continuous process.

The condensation-curable silicone composition of the present invention can comprise additional ingredients, as known in the art and as described above for the hydrosilylation-curable silicone composition.

In yet another embodiment, the silicone composition may be a free radical-curable silicone composition. Examples of free radical-curable silicone compositions include peroxide-curable silicone compositions, radiation-curable silicone compositions containing a free radical photoinitiator, and high energy radiation-curable silicone compositions. Typically, the free radical-curable silicone composition comprises a silicone resin (A⁴) and, optionally, a cross-linking agent (B²) and/or a free radical initiator (C²) (e.g., a free radical photoinitiator or organic peroxide).

The silicone resin (A⁴) can be any silicone resin that can be cured (i.e., cross-linked) by at least one method selected from (i) exposing the silicone resin to radiation having a wavelength of from 150 to 800 nm in the presence of a free radical photoinitiator, (ii) heating the silicone resin (A⁴) in the presence of an organic peroxide, and (iii) exposing the silicone resin (A⁴) to an electron beam. The silicone resin (A⁴) is typically a copolymer containing T siloxane units and/or Q siloxane units in combination with M and/or D siloxane units.

For example, the silicone resin (A⁴) may have the formula (R¹R⁹₂SiO_{1/2})_{w"}(R⁹₂SiO_{2/2})_{x"}(R⁹SiO_{3/2})_{y"}(SiO_{4/2})_{z"}, wherein R¹ is as defined and exemplified above, R⁹ is R¹, alkenyl, or alkynyl, w" is from 0 to 0.99, x" is from 0 to 0.99, y" is from 0 to 0.99, z" is from 0 to 0.85, and w"+x"+y"+z" = 1.

The alkenyl groups represented by R⁹, which may be the same or different, are as defined and exemplified in the description of R² above.

The alkynyl groups represented by R⁹, which may be the same or different, typically have from 2 to about 10 carbon atoms, alternatively from 2 to 6 carbon atoms, and are exemplified by, but are not limited to, ethynyl, propynyl, butynyl, hexynyl, and octynyl.

The silicone resin (A⁴) typically has a number-average molecular weight (Mₙ) of at least 300, alternatively from 500 to 10,000, alternatively from 1,000 to 3,000, where the molecular weight is determined by gel permeation chromatography employing a refractive index detector and silicone resin (MQ) standards.

The silicone resin (A⁴) can contain less than 10% (w/w), alternatively less than 5% (w/w), alternatively less than 2% (w/w), of silicon-bonded hydroxy groups, as determined by ²⁹Si NMR.

Specific examples of silicone resins (A⁴) that are suitable for purposes of the present invention include, but are not limited to, silicone resins having the following formulae:
(Vi₂MeSiO_{1/2})₀.₂₅(PhSiO_{3/2})₀.₇₅, (ViMe₂SiO_{1/2})_{0.25}(PhSiO_{3/2})₀.₇₅, (ViMe₂SiO_{1/2})_{0.25}(MeSiO_{3/2})_{0.25}(PhSiO_{3/2})_{0.50}, (ViMe₂SiO_{1/2})₀.₁₅(PhSiO_{3/2})₀.₇₅ (SiO_{4/2})_{0.1}, and (Vi₂MeSiO_{1/2})_{0.15} (ViMe₂SiO_{1/2})_{0.1} (PhSiO_{3/2})₀.₇₅,
wherein Me is methyl, Vi is vinyl, Ph is phenyl, and the numerical subscripts outside the parenthesis denote mole fractions. The sequence of units in the preceding formulae is not to be viewed in any way as limiting to the scope of the invention.

The free radical-curable silicone composition of the present method can comprise additional ingredients including, but not limited to, silicone rubbers; unsaturated compounds; free radical initiators; organic solvents; UV stabilizers; sensitizers; dyes; flame retardants; antioxidants; fillers, such as reinforcing fillers, extending fillers, and conductive fillers; and adhesion promoters.

The free radical-curable silicone composition can further comprise an unsaturated compound selected from (i) at least one organosilicon compound having at least one silicon-bonded alkenyl group per molecule, (ii) at least one organic compound having at least one aliphatic carbon-carbon double bond per molecule, and (iii) mixtures comprising (i) and (ii), wherein the unsaturated compound has a molecular weight less than 500. Alternatively, the unsaturated compound has a molecular weight of less than 400 or less than 300. Also, the unsaturated compound can have a linear, branched, or cyclic structure.

The organosilicon compound (i) can be an organosilane or an organosiloxane. The organosilane can be a monosilane, disilane, trisilane, or polysilane. Similarly, the organosiloxane can be a disiloxane, trisiloxane, or polysiloxane. Cyclosilanes and cyclosiloxanes typically have from 3 to 12 silicon atoms, alternatively from 3 to 10 silicon atoms, alternatively from 3 to 4 silicon atoms. In acyclic polysilanes and polysiloxanes, the silicon-bonded alkenyl group(s) can be located at terminal, pendant, or at both terminal and pendant positions.

Specific examples of organosilanes include, but are not limited to, silanes having the following formulae:
Vi₄Si, PhSiVi₃, MeSiVi₃, PhMeSiVi₂, Ph₂SiVi₂, and PhSi(CH₂CH=CH₂)₃,
wherein Me is methyl, Ph is phenyl, and Vi is vinyl.

Specific examples of organosiloxanes include, but are not limited to, siloxanes having the following formulae:
PhSi(OSiMc₂Vi)₃, Si(OSiMe₂Vi)₄, MeSi(OSiMe₂Vi)₃, and Ph₂Si(OSiMe₂Vi)₂,
wherein Me is methyl, Vi is vinyl, and Ph is phenyl.

The organic compound can be any organic compound containing at least one aliphatic carbon-carbon double bond per molecule, provided the compound does not prevent the silicone resin (A⁴) from curing to form a silicone resin film. The organic compound can be an alkene, a diene, a triene, or a polyene. Further, in acyclic organic compounds, the carbon-carbon double bond(s) can be located at terminal, pendant, or at both terminal and pendant positions.

The organic compound can contain one or more functional groups other than the aliphatic carbon-carbon double bond. Examples of suitable functional groups include, but are not limited to, -0-, >C=O, -CHO, -CO₂-, -C=N, -NO₂, >C=C<, -C=C-, -F, -Cl, -Br, and -I. The suitability of a particular unsaturated organic compound for use in the free-radical curable silicone composition of the present invention can be readily determined by routine experimentation.

The organic compound can be in a liquid or solid state at room temperature. Also, the organic compound can be soluble, partially soluble, or insoluble in the free-radical curable silicone composition. The normal boiling point of the organic compound, which depends on the molecular weight, structure, and number and nature of functional groups in the compound, can vary over a wide range. Typically, the organic compound has a normal boiling point greater than the cure temperature of the composition. Otherwise, appreciable amounts of the organic compound may be removed by volatilization during cure.

Examples of organic compounds containing aliphatic carbon-carbon double bonds include, but are not limited to, 1,4-divinylbenzene, 1,3-hexadienylbenzene, and 1,2-diethenylcyclobutane.

The unsaturated compound can be a single unsaturated compound or a mixture comprising two or more different unsaturated compounds, each as described above. For example, the unsaturated compound can be a single organosilane, a mixture of two different organosilanes, a single organosiloxane, a mixture of two different organosiloxanes, a mixture of an organosilane and an organosiloxane, a single organic compound, a mixture of two different organic compounds, a mixture of an organosilane and an organic compound, or a mixture of an organosiloxane and an organic compound.

The concentration of the unsaturated compound is typically from 0 to 70% (w/w), alternatively from 10 to 50% (w/w), alternatively from 20 to 40% (w/w), based on the total weight of the free radical-curable silicone composition.

Methods of preparing organosilanes and organosiloxanes containing silicon-bonded alkenyl groups, and organic compounds containing aliphatic carbon-carbon double bonds are well known in the art; many of these compounds are commercially available.

The free radical initiator is typically a free radical photoinitiator or an organic peroxide. Further, the free radical photoinitiator can be any free radical photoinitiator capable of initiating cure (cross-linking) of the silicone resin upon exposure to radiation having a wavelength of from 200 to 800 nm.

Examples of free radical photoinitiators include, but are not limited to, benzophenone; 4,4'-bis(dimethylamino)benzophenone; halogenated benzophenones; acetophenone; α-hydroxyacetophenone; chloro acetophenones, such as dichloroacetophenones and trichloroacetophenones; dialkoxyacetophenones, such as 2,2-diethoxyacetophenone; α-hydoxyalkylphenones, such as 2-hydroxy-2-methyl-1-phenyl-1-propanone and 1-hydroxycyclohexyl phenyl ketone; α-aminoalkylphenones, such as 2-methyl-4'-(methylthio)-2-morpholiniopropiophenone; benzoin; benzoin ethers, such as benzoin methyl ether, benzoin ethyl ether, and benzoin isobutyl ether; benzil ketals, such as 2,2-dimethoxy-2-phenylacetophenone; acylphosphinoxides, such as diphenyl(2,4,6-trimethylbenzoyl)phosphine oxide; xanthone derivatives; thioxanthone derivatives; fluorenone derivatives; methyl phenyl glyoxylate; acetonaphthone; anthraquinone derivatives; sufonyl chlorides of aromatic compounds; and *O*-acyl α-oximinoketones, such as 1-phenyl-1,2-propanedione-2-(O-ethoxycarbonyl)oxime.

The free radical photoinitiator can also be a polysilane, such as the phenylmethylpolysilanes defined by West in U.S. Pat. No. 4,260,780, the disclosure of which as it relates to the phenylmethylpolysilanes is hereby incorporated by reference; the aminated methylpolysilanes defined by Baney et al. in U.S. Pat. No. 4,314,956, the disclosure of which is hereby incorporated by reference as it relates to aminated methylpolysilanes; the methylpolysilanes defined by Peterson et al. in U.S. Pat. No. 4,276,424, the disclosure of which is hereby incorporated by reference as it relates to methylpolysilanes; and the polysilastyrene defined by West et al. in U.S. Pat. No. 4,324,901, the disclosure of which is hereby incorporated by reference as it relates to polysilastyrene.

The free radical photoinitiator can be a single free radical photoinitiator or a mixture comprising two or more different free radical photoinitiators. The concentration of the free radical photoinitiator is typically from 0.1 to 6% (w/w), alternatively from 1 to 3% (w/w), based on the weight of the silicone resin (A⁴)_{.}

The free radical initiator can also be an organic peroxide. Examples of organic peroxides include, diaroyl peroxides such as dibenzoyl peroxide, di-p-chlorobenzoyl peroxide, and bis-2,4-dichlorobenzoyl peroxide; dialkyl peroxides such as di-t-butyl peroxide and 2,5-dimethyl-2,5-di-(t-butylperoxy)hexane; diaralkyl peroxides such as dicumyl peroxide; alkyl aralkyl peroxides such as t-butyl cumyl peroxide and 1,4-bis(t-butylperoxyisopropyl)benzene; and alkyl aroyl peroxides such as t-butyl perbenzoate, t-butyl peracetate, and t-butyl peroctoate.

The organic peroxide can be a single peroxide or a mixture comprising two or more different organic peroxides. The concentration of the organic peroxide is typically from 0.1 to 5% (w/w), alternatively from 0.2 to 2% (w/w), based on the weight of the silicone resin (A⁴).

The free radical-curable silicone composition can further comprise at least one organic solvent. The organic solvent can be any aprotic or dipolar aprotic organic solvent that does not react with the silicone resin (A⁴) or additional ingredient(s) and is miscible with the silicone resin (A⁴). Examples of organic solvents include, but are not limited to, saturated aliphatic hydrocarbons such as n-pentane, hexane, n-heptane, isooctane and dodecane; cycloaliphatic hydrocarbons such as cyclopentane and cyclohexane; aromatic hydrocarbons such as benzene, toluene, xylene and mesitylene; cyclic ethers such as tetrahydrofuran (THF) and dioxane; ketones such as methyl isobutyl ketone (MIBK); halogenated alkanes such as trichloroethane; and halogenated aromatic hydrocarbons such as bromobenzene and chlorobenzene. The organic solvent can be a single organic solvent or a mixture comprising two or more different organic solvents, as described above.

The concentration of the organic solvent is typically from 0 to 99% (w/w), alternatively from 30 to 80% (w/w), alternatively from 45 to 60% (w/w), based on the total weight of the free radical-curable silicone composition.

When the free-radical curable silicone composition described above contains one or more additional ingredients, for example, a free radical initiator, the composition can be a one-part composition comprising the silicone resin and optional ingredient(s) in a single part, or a multi-part composition comprising the components in two or more parts.

Another suitable silicone composition comprises cyclic dihydrogenpolysiloxanes, which have a weight-average molecular weight ranging in value from 1,500 to 1,000,000, are liquid at room temperature (∼23 ± 2 °C), and comprise H₂SiO_{2/2} units. The cyclic dihydrogenpolysiloxanes can be produced by subjecting dichlorosilane (H₂SiCl₂) to hydrolysis/condensation in a mixture of a non-polar organic solvent and water and removing volatile cyclic dihydrogenpolysiloxanes from the formed cyclic dihydrogenpolysiloxanes.

The non-polar organic solvents used herein are exemplified by aromatic hydrocarbon organic solvents and aliphatic hydrocarbon organic solvents, with the aromatic hydrocarbon organic solvents exemplified by toluene and xylene and the aliphatic hydrocarbon organic solvents exemplified by hexane, heptane, octane, and cyclohexane.

The hydrolysis/condensation reaction is typically conducted via slow dropwise addition of a non-polar organic solvent solution of dichlorosilane while stirring the non-polar organic solvent and water. It is preferred to conduct the dropwise addition at a temperature of not more than 5°C in order to prevent volatilization of the dihydrogenpolysiloxane.

The hydrolysis/condensation is typically conducted in a mixture of a non-polar organic solvent phase and an aqueous phase, followed by washing the non-polar organic solvent phase containing the formed cyclic dihydrogenpolysiloxane with water, drying it, and eluting the non-polar organic solvent and volatile cyclic dihydrogenpolysiloxanes.

Once the dropwise addition is complete, allowing the solution to stand causes it to separate into a non-polar organic solvent layer and an aqueous layer, after which the non-polar organic solvent layer is removed and washed with water. Typically, the non-polar organic solvent layer is washed until it becomes neutral or until chlorine ions are no longer detected. The non-polar organic solvent layer may also be washed to a certain extent and neutralized with a weak alkali, e.g. calcium carbonate, sodium carbonate, or sodium bicarbonate, followed by washing the formed salts with water. The washed non-polar organic solvent layer may be dried and the non-polar organic solvent and volatile cyclic dihydrogenpolysiloxanes are typically eluted. Although there are no particular limitations concerning the method used to dry the washed non-polar organic solvent layer so long as it does not alter the cyclic dihydrogenpolysiloxanes, a powdered or granulated drying agent, e.g. anhydrous magnesium sulfate, anhydrous sodium sulfate, or a molecular sieve, may be added. The resulting mixture is subjected to agitation, and the drying agent filtered off. There are also no particular limitations concerning elution of the non-polar organic solvent and cyclic dihydrogenpolysiloxane so long as the cyclic dihydrogenpolysiloxanes are not altered. Elution may be exemplified by heating under reduced pressure or blowing in dry nitrogen gas under heating. The volatile cyclic dihydrogenpolysiloxanes mentioned herein are 3-mers ∼ 15-mers. The fact that the product is a cyclic dihydrogenpolysiloxane is ascertained by the absence of silanol group absorption when analyzed using FT-IR.

The cyclic dihydrogenpolysiloxanes can also be produced by subjecting dichlorosilane to co-hydrolysis/condensation in a mixture of the non-polar organic solvent, hydrochloric acid, and an ionic surface active agent, and removing volatile cyclic dihydrogenpolysiloxanes from the formed dihydrogenpolysiloxanes as described above. The hydrochloric acid is typically concentrated hydrochloric acid, and, more typically, hydrochloric acid with a hydrogen chloride content of 15 wt% to 37 wt%. The ionic surface active agents may include anionic surface active agents, cationic surface active agents, and amphoteric surface active agents, with the anionic surface active agents exemplified by alkali metal salts of aliphatic hydrocarbon sulfonic acids, e.g. alkali metal salts of alkylsulfonic acids of 6 to 20 carbon atoms, alkali metal salts of alkenesulfonic acids of 6 to 20 carbon atoms, and alkali metal salts of alkylbenzenesulfonic acids; aliphatic hydrocarbon sulfonic acids, e.g. alkylsulfonic acids of 6 to 20 carbon atoms, alkenesulfonic acids of 6 to 20 carbon atoms; alkylbenzenesulfonic acids; alkali metal salts of alkylsulfonic esters; and alkali metal salts of higher aliphatic acids. Sodium and potassium are preferred as the alkali metals used herein. The cationic surface active agents are exemplified by quaternary ammonium salts, e.g. tetramethylammonium chloride, benzyltributylammonium chloride, cetyltrimethylammonium chloride, and tetrabutylammonium chloride; and by alkylamine hydrochlorides, e.g. decylamine hydrochloride. The ionic surface active agents are typically used in an amount of from 0.01∼50 wt%, more typically from 0.1∼1.0 wt%, of the water contained in the hydrochloric acid.

Typically, the hydrolysis/condensation reaction is carried out via dropwise addition of the non-polar organic solvent solution containing dichlorosilane to a mixture including the non-polar organic solvent, hydrochloric acid, and the ionic surface active agent. Typically, agitation is continued during the dropwise addition. The hydrolysis/condensation reaction typically occurs at a temperature of not more than 5°C in order to prevent volatilization of the dichlorosilane.

Another suitable silicone composition comprises hydrogenpolysiloxanes having a siloxane unit formula of [H₂SiO_{2/2}]ₓ'"[HSiO_{3/2}]y"' [SiO_{4/2]z}'" where x"', y"', and z"' represent mole fractions, 0.12 ≤ x'" < 1.0, 0 ≤ y"' ≤ 0.88, 0 ≤ z"' ≤0.30, y'" and z'" are not simultaneously 0, and x'" + y"' + z"' = 1. The hydrogenpolysiloxanes typically have a weight-average molecular weight ranging in value from 500 to 1,000,000 and are liquid at temperatures of 120°C or less.

When z"' = 0 in the siloxane unit formula [H₂SiO_{2/2}]_{x'''}[HSiO_{3/2}]_{y"'}[SiO_{4/2}]_{z'"}, the hydrogenpolysiloxanes is described by the siloxane unit formula [H₂SiO_{2/2}]_{x"'}[HSiO_{3/2}]_{y'"} wherein x'" and y"' represent mole fractions as set forth above and x"' + y"' = 1. When z'" = 0, typically 0.15 ≤ x"' < 1.0 and 0 < y"' ≤ 0.85 because when x'" is smaller than 0.15, the degree of branching increases and cracking becomes more likely to happen upon cure.

When y"' = 0 in the siloxane unit formula [H₂SiO_{2/2}]ₓ"'[HSiO_{3/2}]_{y}"'[SiO_{4/2}]_{z}"', the hydrogenpolysiloxanes is described by the siloxane unit formula [H₂SiO_{2/2}]ₓ'"[SiO_{4/2}]_{z}'" wherein x"' and z"' represent mole fractions as set forth above and x"' + z"' = 1. When y"' = 0, typically 0.15 ≤ x"' <1.0 because when x'" is smaller than 0.15, the degree of branching increases and cracking becomes more likely to happen upon cure, and 0 < z"' ≤ 0.15 because when z"' is larger than 0.15, the degree of branching increases and cracking becomes more likely to happen upon cure.

On the average, the hydrogenpolysiloxanes have the above-mentioned siloxane unit formulas in mole fractions of x"', y"', and z"', which does not imply an arrangement in the order of the above-mentioned siloxane units. When siloxane units are arranged randomly in the hydrogenpolysiloxanes, there may be cases in which some block portions are present, but the rest of the units are arranged in a random fashion. Since [H₂SiO_{2/2}] units are always present, there may be linear blocks, but because there are always [HSiO_{3/2}] units and/or [SiO_{4/2}] units, the molecular structure is at least branched and may be network- or cage-like as well, i.e. it could be a resin. When the hydrogenpolysiloxanes have [SiO_{4/2}] units, the degree of branching increases even more.

The hydrogenpolysiloxanes can be produced by a process wherein (A') dichlorosilane (H₂SiCl₂), (B') trichlorosilane (HSiCl₃), and (C') tetraalkoxysilane (Si(OR)₄) or tetrachlorosilane (SiCl₄) are subjected to co-hydrolysis/condensation in mole ratios such that 0.12 ≤ (A') < 1.0, 0 ≤ (B) ≤ 0.88, 0 ≤ (C') ≤ 0.30, (A') and (B') are not simultaneously 0, and (A') + (B') + (C') = 1 in a mixture of a non-polar organic solvent, hydrochloric acid, and an ionic surface active agent, whereupon the formed hydrogenpolysiloxane-containing non-polar organic solvent layer is washed with water, dried, and the non-polar organic solvent is eluted together with volatile hydrogenpolysiloxanes. In this instance, R stands for an alkyl group, typically ethyl, and can be a methyl or propyl group as well. The specific method steps are performed in the same manner as set forth above for the cyclic dihydrogenpolysiloxanes.

In addition, hydrogenpolysiloxanes of the siloxane unit formula [H₂SiO_{2/2}]_{x'''}[HSiO_{3/2}]_{y'"} can be produced via co-hydrolysis of (A') dichlorosilane (H₂SiCl₂) and (B') trichlorosilane (HSiCl₃), and hydrogenpolysiloxanes of the siloxane unit formula [H2SiO_{2/2}]_{x'''}[SiO_{4/2}]_{z'''} (wherein x"' and z'" represent mole fractions, 0.12 ≤ x'" < 1.0, 0 < z"' ≤ 0.30, and x"' + z"' = 1) can be produced via co-hydrolysis of (A') dichlorosilane (H₂SiCl₂) and (C') tetraalkoxysilane (Si(OR)₄) or tetrachlorosilane (SiCl₄).

The hydrochloric acid is typically concentrated hydrochloric acid, and, even more typically, hydrochloric acid with a hydrogen chloride content of 15 wt% to 37 wt%. Because water contained in the hydrochloric acid is used for the hydrolysis of (A') dichlorosilane (H₂SiCl₂), (B') trichlorosilane (HSiCl₃), and (C') tetraalkoxysilane (Si(OR)₄) or tetrachlorosilane (SiCl₄), the hydrochloric acid is typically used in an amount that is equal to or higher than the equimolar amount necessary for the hydrolysis of (A') dichlorosilane (H₂SiCl₂), (B') trichlorosilane (HSiCl₃), and (C') tetraalkoxysilane (Si(OR)₄) or tetrachlorosilane (SiCl₄).

The ionic surface active agents are described above and suppress gelling due to independent condensation and rapid hydrolysis/condensation of trichlorosilane and promote its co-hydrolysis/condensation with dichlorosilane.

When the cyclic dihydrogenpolysiloxanes, as well as the hydrogenpolysiloxanes that have the siloxane unit formula of [H₂SiO_{2/2}]ₓ'''[HSiO_{3/2}]_{y}'''[SiO_{4/2}]_{z}''', are heated to a temperature of 120°C or higher, silicon-bonded hydrogen is turned into hydroxyl groups via an oxidation reaction and crosslinking takes place as a result of a dehydration condensation reaction with the silicon-bonded hydrogen atoms. In other words, crosslinking and curing take place as a result of forming Si-O-Si bonds. In wet ammonia, hydrogen atoms directly bonded to silicon become activated and turn into hydroxyl groups by readily reacting with moisture in the air, thereby causing a dehydration condensation reaction with silicon-bonded hydrogen atoms and cross-linking. As a result, silica (silicon oxide) is formed. However, there is no need to eliminate all hydrogen atoms directly bonded to silicon atoms in the molecules of the above-mentioned cyclic dihydrogenpolysiloxanes and the above-mentioned hydrogenpolysiloxanes and some of the hydrogen atoms, for instance, 60 mol% or less, may be left intact.

The heating may occur in an oxygen atmosphere. Air is a representative example of the oxygen atmosphere. The oxygen atmosphere may alternatively be an oxygen gas-containing nitrogen gas or helium gas with an oxygen concentration lower than that of air. Alternatively, exposure to ozone, nitrous oxide, or wet ammonia may be used to induce reaction of the cyclic dihydrogenpolysiloxanes and hydrogenpolysiloxanes. The ozone is exemplified by pure ozone, ozone-containing air, steam-containing ozone, and ozone-containing nitrogen gas, any of which can be used. The reaction, when induced by ozone, occurs in a more efficient manner than when the reaction is induced by atmospheric oxygen. The nitrous oxide is exemplified by pure nitrous oxide gas, nitrous oxide-containing air, and nitrous oxide-containing nitrogen gas, any of which can be used. The wet ammonia is exemplified by ammonia-containing air, ammonium hydroxide gas, and nitrogen gas containing ammonia and steam, any of which can be used. The exposure to ozone, exposure to nitrous oxide, or exposure to ammonia may be carried out under heating.

The above-mentioned cyclic dihydrogenpolysiloxanes and hydrogenpolysiloxanes may also be cured by high-energy irradiation. Electron beams and X-rays are representative examples of such irradiation. The amount of electron beam irradiation is typically not less than 3 Gry.

In one embodiment, as shown in Figure 3, the silicone layer **306** of the substrate **106** may further include the fiber reinforcement **302**. In this embodiment, the substrate **106** may include other layers in addition to the silicone layer **306**, but may alternatively include the silicone layer **306** alone. The fiber reinforcement **302** in the silicone layer **306** may enhance mechanical strength of the substrate **106** and may reduce the coefficient of thermal expansion of the cured silicone composition **304** in the silicone layer **306**, thereby improving manufacturability of the CdTe-based photovoltaic devices **104**.

The fiber reinforcement **302** can be any reinforcement comprising fibers. Typically, the fiber reinforcement **302** typically has a high modulus and high tensile strength. The fiber reinforcement **302** typically has a Young's modulus at 25 °C of at least 3 GPa. For example, the fiber reinforcement **302** typically has a Young's modulus at 25 °C of from 3 to 1,000 GPa, alternatively from 3 to 200 GPa, alternatively from 10 to 100 GPa. Moreover, the fiber reinforcement **302** typically has a tensile strength at 25 °C of at least 50 MPa. For example, the reinforcement typically has a tensile strength at 25 °C of from 50 to 10,000 MPa, alternatively from 50 to 1,000 MPa, alternatively from 50 to 500 MPa.

The fiber reinforcement **302** can be a woven fabric, e.g., a cloth; a nonwoven fabric, e.g., a mat or roving; or loose (individual) fibers. In a non-limiting example, the fiber reinforcement **302** has a width **310** of 100 µm to 200 µm, and a thickness of 20 µm to 40 µm. The fibers **308** in the reinforcement 302 are typically cylindrical in shape and have a diameter of from 1 to 100 µm, alternatively from 1 to 20 turn, alternatively form 1 to 10 µm. Loose fibers are typically continuous, meaning the fibers **308** extend throughout the silicone layer **306** in a generally unbroken manner. Fibers with oblong cross-sectional shape can also be used.

The fiber reinforcement **302** is typically heat-treated prior to use to remove organic contaminants. For example, the fiber reinforcement **302** is typically heated in air at an elevated temperature, for example, 575 °C, for a suitable period of time, for example 2 h.

Specific examples of fiber reinforcements **302** that are suitable for purposes of the present invention include, but are not limited to, reinforcements comprising glass fibers; quartz fibers; graphite fibers; nylon fibers; polyester fibers; aramid fibers, such as Kevlar® and Nomex®; polyethylene fibers; polypropylene fibers; and silicon carbide fibers.

In addition to the fiber reinforcement **302**, the silicone layer **306** of the substrate **106** can further include one or more nano fillers, such as the silica nanoparticles set forth above, to mitigate thermal cracking and to increase mechanical integrity. The fiber reinforcement **302** provides a macro-scale continuous reinforcement, and the nano filler provides a nano-scale discontinuous reinforcement. The fiber reinforcement **302** and the nano fillers in the silicone layer **306** work together to maximize resistance to stress in the substrate **106**. Resistance to stress enables the substrate **106** to withstand the annealing temperatures in excess of 500 °C without exhibiting substantial cracking.

Suitable nano fillers that may be included in the silicone layer **306** of the substrate **106** include, but are not limited to, functionalized carbon nanofiber; aluminum-based fillers such as aluminum oxide and aluminum trihydroxide; boron-based fillers such as boric oxide and boric acid; mica; colloidal silica, and combinations thereof. The silica nanoparticles set forth above are also suitable nano fillers, especially for condensation-curable silicone compositions. Typically, the nano fillers have a diameter of less than 1 µm, typically less than 200 nm. A specific example of a suitable nano filler for purposes of the present invention is Pyrograph III carbon nanofiber commercially available from Applied Sciences, Inc. of Cedarville, OH.

The fiber reinforcement **302** can be impregnated with the silicone composition. The nano fillers are typically mixed into the silicone resin using conventional mixing methods prior to impregnating the fiber reinforcement **302** with the silicone composition. The fiber reinforcement **302** can be impregnated with the silicone composition using a variety of methods. For example, the silicone composition, as described above, may be applied to a release liner to form a silicone film. The silicone composition can be applied to the release liner using conventional coating techniques, such as spin coating, dipping, spraying, brushing, or screenprinting. The silicone composition is typically applied in an amount sufficient to embed the fiber reinforcement **302** therein. The release liner can be any rigid or flexible material having a surface from which the silicone layer **306** can be removed without damage by delamination after the silicone composition is cured. Examples of release liners include, but are not limited to, nylon, polyethyleneterephthalate, and polyimide.

The fiber reinforcement **302** is then embedded in the silicone film, thereby forming an embedded fiber reinforcement. The fiber reinforcement **302** can be embedded in the silicone film by simply placing the reinforcement on the silicone film and allowing the silicone composition to saturate the reinforcement. However, it is to be appreciated that the fiber reinforcement **302** may be first deposited on the release liner, followed by the application of the silicone composition onto the fiber reinforcement **302**. In another embodiment, when the fiber reinforcement **302** is woven or nonwoven fabric, the reinforcement can be impregnated with the silicone composition by passing the fiber reinforcement **302** through the silicone composition without the used of the release liner. The fabric is typically passed through the silicone composition at a rate of from 1 to 1,000 cm/s at room temperature (∼23 ± 2 °C).

The embedded fiber reinforcement is then typically degassed. The embedded fiber reinforcement can be degassed by subjecting it to a vacuum at a temperature of from room temperature (∼23 ± 2 °C) to 60 °C, for a period of time sufficient to remove entrapped air. For example, the embedded fiber reinforcement can typically be degassed by subjecting the embedded fiber reinforcement to a pressure of from 1,000 to 20,000 Pa for 5 to 60 minutes at room temperature.

After degassing, additional silicone composition may be applied to the embedded fiber reinforcement to form an impregnated fiber reinforcement. The silicone composition can be applied to the degassed embedded fiber reinforcement using conventional methods, as described above. Additional cycles of degassing and application of silicone composition may also occur.

The impregnated fiber reinforcement may also be compressed to remove excess silicone composition and/or entrapped air, and to reduce the thickness of the impregnated fiber reinforcement. The impregnated fiber reinforcement can be compressed using conventional equipment such as a stainless steel roller, hydraulic press, rubber roller, or laminating roll set. The impregnated fiber reinforcement is typically compressed at a pressure of from 1,000 Pa to 10 MPa and at a temperature of from room temperature (∼23 + 2 °C) to 50 °C.

Typically, the silicone composition in the impregnated fiber reinforcement is then cured to form the silicone layer **306** of the substrate **106**. "Cured" as defined herein means that the silicone composition, which can be in the form of the component parts, a mixture, a solution, or a blend, is exposed to room temperature air, heated at elevated temperatures, or exposed to UV, electron beam, or microwave. Heating can occur using any known conventional means such as by placing the silicone composition or, in this case, the impregnated fiber reinforcement, into an air circulating oven. The impregnated fiber reinforcement can be heated at atmospheric, sub-atmospheric, or supra-atmospheric pressure. The impregnated fiber reinforcement is typically heated at a temperature of from room temperature (∼23 ± 2 °C) to 250 °C, alternatively from room temperature to 200 °C, alternatively from room temperature to 150 °C, at atmospheric pressure. The impregnated fiber reinforcement is heated for a length of time sufficient to cure (cross-link) the silicone composition. For example, the impregnated fiber reinforcement is typically heated at a temperature of from 150 to 200 °C for a period of from 0.1 to 3 h.

Alternatively, the impregnated fiber reinforcement can be heated in a vacuum at a temperature of from 100 to 200 °C and a pressure of from 1,000 to 20,000 Pa for a time of from 0.5 to 3 h to form the reinforced silicone film. The impregnated fiber reinforcement can be heated in the vacuum using a conventional vacuum bagging process. In a typical process, a bleeder (e.g., polyester) is applied over the impregnated fiber reinforcement, a breather (e.g., nylon, polyester) is applied over the bleeder, a vacuum bagging film (e.g., nylon) equipped with a vacuum nozzle is applied over the breather, the assembly is sealed with tape, a vacuum (e.g., 1,000 Pa) is applied to the sealed assembly, and the evacuated bag is heated as described above.

The silicone layer **306** of the substrate **106**, when the fiber reinforcement **302** and/or the nano filler are present in the silicone layer **306**, typically comprises, on a pre-curing weight basis, from 10 to 99% (w/w), alternatively from 30 to 95% (w/w), alternatively from 60 to 95% (w/w), alternatively from 80 to 95% (w/w), of the silicone composition. The fiber reinforcement **302** is typically present in the silicone layer 306 in an amount of at least 5 % (w/w), more typically in an amount of from 20 to 50 % (w/w). The nano filler is typically present in the substrate **106** in an amount of at least 0.003% (w/w), alternatively from 0.003 to 20% (w/w), alternatively from 0.003 to 0.2% (w/w).

The substrate **106**, when the fiber reinforcement **302** and/or the nano filler are present in the silicone layer **306**, typically has a thickness of from 15 to 500 µm, alternatively from 15 to 300 µm, alternatively from 20 to 300 µm, alternatively from 25 to 200 µm.

In another embodiment, as shown in Figure 4, the substrate **106** includes the silicone layer **306** formed from the silicone composition and a metal foil layer **312**. Typically, the silicone layer **306** and the metal foil layer **312** are laminated to each other. The metal foil layer **312** is typically formed from a metal such as stainless steel, titanium, covar, invar, tantalum, brass, niobium, and combinations thereof.

The substrate **106** including the silicone layer **306** and the metal foil layer **312** typically has a thickness of from 2 to 1006 µm, alternatively from 15 to 500 µm. Within the substrate **106**, the silicone layer **306** typically has a thickness of from 0.5 to 6 µm and the metal foil layer **312** typically has a thickness of from 12.5 to 1000 µm.

Among other excellent physical properties, the substrates **106**, i.e., both the substrate **106** including the silicone layer **306** with the fiber reinforcement 302 and the substrate **106** including the silicone layer **306** and the metal foil layer **312**, typically have a flexibility such that the substrate **106** can be bent over a cylindrical steel mandrel having a diameter less than or equal to 3.2 mm without cracking, where the flexibility is determined as described in ASTM Standard D522-93a, Method B.

The substrate **106** typically has a low coefficient of linear thermal expansion (CTE), high tensile strength, and a high modulus. For example the substrate **106** typically has a CTE of from 0 to 80 µm/m°C, alternatively from 0 to 20 µm/m°C, alternatively from 2 to 10. µm/m°C, at temperatures of from room temperature (∼23 ± 2 °C) to 200°C. Also, the substrate **106** typically has a tensile strength at 25 °C of from 50 to 200 MPa, alternatively from 80 to 200 MPa, alternatively from 100 to 200 MPa. Further, the substrate **106** typically has a Young's modulus at 25 °C of from 2 to 10 GPa, alternatively from 2 to 6 GPa, alternatively from 3 to 5 GPa.

The transparency of the substrate **106**, when the metal foil layer **312** is absent and the fiber reinforcement and nano filler are present, depends on a number of factors, such as the composition of the cured silicone composition, the thickness of the substrate **106**, and the refractive index of the fiber reinforcement **302**. The substrate **106** including the silicone layer **306** with the fiber reinforcement **302** and/or the nano filler typically has a transparency (% transmittance) of at least 15%, alternatively at least 60%, alternatively at least 75%, alternatively at least 85%, in the visible region of the electromagnetic spectrum.

The CdTe-base photovoltaic device **104** is prepared by depositing various layers of materials onto the substrate **106**. The various layers are deposited or modified in separate chambers.

To prepare the CdTe-base photovoltaic device **104**, the substrate **106** is provided. The substrate **106** may be provided by preparing the substrate **106** as set forth above. Alternatively, the substrate **106** may be obtained from a third party. Typically, a bare starter roll, or strip, of the substrate **106** may be supplied from a pay-out roll. This substrate **106** typically has a width of about 33 cm, a thickness of about 0.005 cm, and a length of up to about 300 meters. The width, thickness and length dimensions are, of course, matters of choice, depending on the ultimate intended application for the CdTe-based photovoltaic device **104**.

Two layers of molybdenum (Mo) **504** are typically formed on opposite sides, or faces, of the substrate **106**. The Mo layers **504** each include entrained oxygen and each possess a certain level of desirable, internal compressive stress. One Mo layer **504** forms a back contact layer **504** for the CdTe-based photovoltaic device **104** of the present invention. The substrate **106** including the Mo layers **504** is then exposed to a vacuum sputtering environment to create a CdTe layer **506** formed from CdTe.

Alternatively, a layer formed from ZnO:Al (not shown) may be formed in place of the Mo layers **504**. The ZnO:Al layer may be formed through RF sputtering onto the substrate **106**. A layer formed from cadmium sulfate (CdS) (not shown) may then be formed on top of the ZnO:Al layer. The substrate **106** including the ZnO:Al layer and the CdS layer is then exposed to the vacuum sputtering environment to form the CdTe layer formed from CdTe.

The CdTe layer **506** is then formed on at least one of the Mo layers **504** or the CdS layer through methods that are known in the art. CdTe, as used herein, refers to cadmium and telluride, and may also include additional metals, such as gallium, aluminum, boron, or sulfur. These different compositions, among others can be used essentially interchangeably as the absorber layer depending on the particular properties desired in the CdTe-based photovoltaic device **104**.

With one configuration when the CdTe layer is deposited on top of a Mo layer, a window or buffer layer **508** also formed from CdS is optionally applied over the CdTe layer **506**. The window or buffer layer **508** is preferably applied in a non-wet manner by radio-frequency (RF) sputtering.

After the CdS layer **508** is formed over the CdTe layer **506**, the CdS layer **508** is treated with CdCl₂, after which a top contact layer **510** in the form of a transparent, conductive-oxide overlayer, such as an ITO or ZnO:Al layer, is formed upon the CdS layer **508**. Figure 5 illustrates the order of layers in a CdTe-based photovoltaic device **104**.

The CdTe-based photovoltaic devices **104** of the present invention are capable of having an efficiency of up to, and may be in excess of, 14%. Although efficiency of up to 14% can be achieved using the substrate **106** of the present invention, experimentation is required to obtain process conditions that result in maximized efficiency.

The following examples are meant to illustrate the invention and are not to be viewed in any way as limiting to the scope of the invention.

### Example 1

### CdTe cell on a reinforced silicone resin film superstrate

A glass fabric reinforced substrate formed from a silicone composition including 0-3015 silicone resin, approximately 75 micrometer thick and coated with a 1 micrometer thick Crystal Coat MP101 resin from SDC Coating Technologies, Inc, was mounted onto a 3.5"X3.5" square shaped open frame. The frame with the substrate was placed in a deposition chamber and a 200 nm ZnO:Al layer was RF sputter coated onto the substrate at 250 °C and in a 10⁻⁵ torr Argon atmosphere. The coated substrate was taken out of the chamber once cooled. The conductivity of the ZnO:Al film was checked and the coated substrate was placed in a separate chamber. The temperature was raised to 150 °C and pressure was lowered to 10⁻⁵ torr with an Argon atmosphere. A 20 nm thick CdS layer was magnetron sputtered onto the ZnO:Al layer from a CdS target. Then a 1 micrometer thick CdTe layer was similarly sputtered on the top of CdS from a CdTe target. The cooled stack, once taken out of the chamber, was treated with CdCl₂ at 396 °C for 15 minutes in an air atmosphere. After this treatment step 150 nm thick Cu round dots were sputtered onto the top of CdTe layer. A 20 nm thick Au layer was finally placed on top of the Cu dots to complete the photovoltaic device. The photovoltaic device was measured under AM1.5 illuminating condition with the incident light coming through the substrate. Peak efficiency of the photovoltaic device was 3.55 %, open circuit voltage was 0.718 V, short circuit current was 17.277 mA/cm², and form factor was 28.632%.

### Example 2

### CdTe cell on a reinforced silicone resin film substrate

A glass fabric reinforced substrate formed from a silicone composition including T^{Me}/SiO₂ silicone resin, approximately 50 micrometer thick, was mounted onto a 3.5"X3.5" square shaped open frame. The frame with the film was placed in a deposition chamber and a 200 nm Mo layer was sputtered onto the film at 250 °C. The coated film was taken out of the chamber once cooled. It was placed in a separate chamber with the temperature raised to 150 °C and pressure lowered to 10⁻⁵ torr with an Argon atmosphere. A 1 micrometer thick CdTe layer was magnetron sputtered onto the Mo layer from a CdTe target. Then a 20 nm thick CdS layer was similarly sputtered on the top of CdTe from a CdS target. The cooled coated substrate **106**, once taken out of the chamber, was treated with CdCl₂ at 396 °C for 15 minutes in an air atmosphere. After this treatment step a 200 nm thick ZnO:Al layer was RF sputtered onto the CdS layer. Then 150 nm thick Cu round dots were sputtered onto the top of ZnO:Al layer. A 20 nm thick Au layer was finally placed on top of the Cu dots to complete the photovoltaic device **104**. The photovoltaic device **104** was measured under AM1.5 illuminating condition with the incident light coming through the substrate **106**. Peak efficiency of the photovoltaic device **104** was 4.75 %, open circuit voltage was 0.599 V, short circuit current was 17.671 mA/cm², and form factor was 44.649%.

The invention has been described in an illustrative manner, and it is to be appreciated that the terminology which has been used is intended to be in the nature of words of description rather than of limitation. Obviously, many modifications and variations of the present invention are possible in view of the above teachings. It is, therefore, to be appreciated that within the scope of the claims the invention may be practiced otherwise than as specifically described.

## Claims

1. A cadmium telluride (CdTe)-based photovoltaic device (**104**) comprising:
a CdTe layer comprising cadmium and telluride; and
a substrate (**106**) including a silicone layer (**306**) formed from a silicone composition and a metal foil layer (**312**);
wherein said silicone composition comprises a silicone resin having:
1) at least one of RSiO_{3/2} or SiO_{4/2}; and
2) at least one of HRSiO_{2/2} or HR₂SiO_{1/2};
wherein R is selected from the group of a C₁ to C₁₀ hydrocarbyl group free of aliphatic unsaturation, a C₁ to C₁₀ halogen-substituted hydrocarbyl group free of aliphatic unsaturation, or hydrogen.

2. A cadmium telluride-based photovoltaic device (**104**) as set forth in claim 1 wherein said CdTe layer further comprises an element selected from the group of gallium, aluminum, boron, sulfur, and combinations thereof.

3. A cadmium telluride-based photovoltaic device (**104**) as set forth in any preceding claim wherein the metal foil layer (**312**) is formed from a metal selected from the group of stainless steel, titanium, covar, invar, tantalum, brass, niobium, and combinations thereof.

4. A cadmium telluride-based photovoltaic device (**104**) as set forth in any preceding claim wherein said metal foil layer (**312**) has a thickness of from 12.5 to 1000 *µ*m.

5. A cadmium telluride-based photovoltaic device (**104**) as set forth in any preceding claim wherein said silicone composition is further defined as a hydrosilylation-curable silicone composition comprising:
(A) said silicone resin;
(B) an organosilicon compound having an average of at least two silicon-bonded alkenyl groups per molecule, and present in an amount sufficient to cure said silicone resin; and
(C) a catalytic amount of a hydrosilylation catalyst.

6. A cadmium telluride-based photovoltaic device (**104**) as set forth in claim 5 wherein said silicone resin has the formula:
(R¹R²₂SiO_{1/2})_{w}(R²₂SiO_{2/2})ₓ (R²SiO_{3/2})_{y}(SiO_{4/2})_{z}
wherein R¹ is a C₁ to C₁₀ hydrocarbyl group or a C₁ to C₁₀ halogen-substituted hydrocarbyl group, both free of aliphatic unsaturation, R2 is R1, an alkenyl group, or hydrogen, w is from 0 to 0.9, x is from 0 to 0.9, y is from 0 to 0.99, z is from 0 to 0.85, w+x+y+z=1, y+z/(w+x+y+z) is from 0.1 to 0.99, and w+x/(w+x+y+z) is from 0.01 to 0.9, provided said silicone resin has an average of at least two silicon-bonded hydrogen atoms per molecule.

7. A cadmium telluride-based photovoltaic device (**104**) as set forth in claim 5 wherein said silicone resin is further defined as a rubber-modified silicone resin comprising the reaction product of:
(A) a silicone resin having the formula:
(R¹R²₂SiO_{1/2})_{w}(R²₂SiO_{2/2})ₓ (R²SiO_{3/2})_{y}(SiO_{4/2})_{z}
wherein R¹ is a C₁ to C₁₀ hydrocarbyl group or a C₁ to C₁₀ halogen-substituted hydrocarbyl group, both free of aliphatic unsaturation, R2 is R1, an alkenyl group, or hydrogen, w is from 0 to 0.9, x is from 0 to 0.9, y is from 0 to 0.99, z is from 0 to 0.85, w+x+y+z=1, y+z/(w+x+y+z) is from 0.1 to 0.99, and w+x/(w+x+y+z) is from 0.01 to 0.9, and
(D)(iii) at least one silicone rubber selected from rubbers having the formula:
R⁵R¹₂SiO(R¹R⁵SiO)_{c}SiR¹₂R⁵,
and
R¹R²₂SiO(R²₂SiO)_{d}SiR²₂R¹,
wherein c and d each have a value of from 4 to 1000,
in the presence of the hydrosilylation catalyst (c) and,
optionally, in the presence of an organic solvent, provided that when said silicone resin (A) has silicon-bonded alkenyl groups, (D)(iii) has silicon-bonded hydrogen atoms, and when said silicone resin (A) has silicon-bonded hydrogen atoms, (D)(iii) has silicon-bonded alkenyl groups.

8. A cadmium telluride-based photovoltaic device (**104**) as set forth in any preceding claim wherein said silicone composition further includes an inorganic filler in particulate form.

9. A cadmium telluride-based photovoltaic device (**104**) as set forth in claim 8 wherein said inorganic filler is further defined as silica nanoparticles having at least one physical dimension less than about 200 nm.

10. A cadmium telluride-based photovoltaic device (**104**) as set forth in any preceding claim wherein said silicone resin comprises hydrogenpolysiloxanes having a siloxane unit formula of [H₂SiO_{2/2}]_{x'"}[HSiO_{3/2}]_{y'"}[SiO_{4/2}]_{z'"} where x"', y"', and z'" represent mole fractions, 0.12 ≤x''' < 1.0, 0 ≤y"' ≤0.88, 0 ≤'" ≤0.30, y''' and z''' are not simultaneously 0, and x"' + y"' + z"' = 1.

11. A cadmium telluride-based photovoltaic device (**104**) as set forth in any preceding claim wherein said silicone resin has HSiO_{3/2}.

12. A cadmium telluride-based photovoltaic device (**104**) as set forth in any one of claims 1 to 10 wherein said silicone resin has H₂SiO_{2/2}.

13. An array (**102**) including a plurality of said cadmium telluride-based photovoltaic devices (**104**) set forth in any preceding claim.

14. A method of preparing a cadmium telluride-based photovoltaic device (**104**) comprising the steps of:
providing a substrate (**106**) including a silicone layer (**306**) formed from a silicone composition and a metal foil layer;
forming a CdTe layer (**506**) comprising cadmium and telluride on the substrate (**106**);
wherein the silicone composition comprises a silicone resin having:
1) at least one of RSiO_{3/2} or SiO_{4/2}; and
2) at least one of HRSiO_{2/2} or HR₂SiO_{1/2};
wherein R is selected from the group of a C₁ to C₁₀ hydrocarbyl group free of aliphatic unsaturation, a C₁ to C₁₀ halogen-substituted hydrocarbyl group free of aliphatic unsaturation, or hydrogen.
